# EUROPEAN PATENT APPLICATION

(11) **EP 4 598 320 A1**
(43) Date of publication of application: **06.08.2025**
(21) Application number: 25153087.9
(22) Date of filing: 21.01.2025
(51) Int. Cl.: H10K 59/121, H10K 59/124, H10K 59/80

(54) **DISPLAY APPARATUS AND METHOD OF MANUFACTURING THE SAME**

(30) Priority: 30.01.2024 KR 20240014317
(71) Applicant: Samsung Display Co., Ltd., Yongin-si, Gyeonggi-do 17113 (KR)
(72) Inventor: LEE, Jongchan, 17113 Yongin-si, Gyeonggi-do (KR); SHIN, Jonghwan, 17113 Yongin-si, Gyeonggi-do (KR); OH, Yuri, 17113 Yongin-si, Gyeonggi-do (KR); YOO, Kibok, 17113 Yongin-si, Gyeonggi-do (KR); LEE, Donghyeok, 17113 Yongin-si, Gyeonggi-do (KR); LEE, Jinsuk, 17113 Yongin-si, Gyeonggi-do (KR)
(74) Representative: Gulde & Partner

(57) **Abstract**

A display apparatus includes a substrate including a first area, a second area surrounding at least a portion of the first area, and a third area between the first area and the second area. A light-emitting diode is arranged in the second area. A first separator is arranged in the third area. The first separator includes an organic pattern layer having a groove. A metal pattern layer is disposed on the organic pattern layer and includes a tip extending towards a center of the groove. In a cross-section, a top surface of the organic pattern layer includes a first point having a greatest vertical distance from the substrate. An imaginary line passing through the first point of the organic pattern layer and an edge of the tip of the metal pattern layer has a declined slope extending in a direction towards the top surface of the substrate.

## Description

### 1. TECHNICAL FIELD

One or more embodiments relate to a display apparatus and a method of manufacturing the display apparatus.

### 2. DISCUSSION OF RELATED ART

Recently, display apparatuses have been applied to a variety of electronic devices and are used for various purposes. Due to a reduction in the thickness and weight of display apparatuses, the use of display apparatuses has been increasing.

As the size of display areas in display apparatuses has increased, various functions that are incorporated in, or connected to, display apparatuses have been added. Research has been conducted to arrange various components in some portions of the display areas of the display apparatuses to add various functions while increasing the size of the display areas.

### SUMMARY

One or more embodiments include a display apparatus having areas to arrange various kinds of components and of which the reliability has been increased, and a method of manufacturing the display apparatus. However, this is merely an example, and the scope of embodiments of the present disclosure are not necessarily limited thereto.

Additional aspects will be set forth in part in the description which follows and, in part, will be apparent from the description, or may be learned by practice of the presented embodiments of the disclosure.

According to an embodiment of the present disclosure, a display apparatus includes a substrate including a first area, a second area surrounding at least a portion of the first area, and a third area between the first area and the second area. A light-emitting diode is arranged in the second area and includes a subpixel electrode, a counter electrode, and an intermediate layer between the subpixel electrode and the counter electrode. A first separator is arranged in the third area. The first separator includes an organic pattern layer having a groove. A metal pattern layer is disposed on the organic pattern layer and includes a tip extending towards a center of the groove. In a cross-section, a top surface of the organic pattern layer includes a first point having a greatest vertical distance from the substrate. An imaginary line passing through the first point of the organic pattern layer and an edge of the tip of the metal pattern layer has a declined slope extending in a direction towards the top surface of the substrate. The tip may include a portion that is a part of the metal pattern layer and does not directly contact the organic pattern layer.

An angle formed by the virtual line passing the first point of the organic pattern layer and the edge of the tip of the metal pattern layer and the top surface of the substrate may be greater than 0° but less than 90°. The tip of the metal pattern layer may have a declined slope extending in the direction towards the top surface of the substrate along the slope of the top surface of the organic pattern layer on which the metal pattern layer is disposed.

In an embodiment, the organic pattern layer may include a first portion overlapping the groove and a second portion outside the first portion. The second portion does not overlap the groove. A top surface of the second portion may include a slope.

In an embodiment, the metal pattern layer may at least partially cover the top surface and an outer surface of the organic pattern layer.

In an embodiment, at least a portion of the tip of the metal pattern layer may have a declined slope extending in the direction towards the top surface of the substrate.

In an embodiment, at least a portion of the tip of the metal pattern layer may extend parallel to the top surface of the substrate.

In an embodiment, at least a portion of the tip of the metal pattern layer may have an inclined slope extending in a direction away from the top surface of the substrate.

In an embodiment, the display apparatus may further include an inorganic insulating layer disposed on the substrate. The organic pattern layer is disposed directly on the inorganic insulating layer. A second separator is spaced apart from the first separator, in the third area. The third area may include an inorganic contact region in an interval between the first separator and the second separator. The metal pattern layer directly contacts a top surface of the inorganic insulating layer in the inorganic contact region.

In an embodiment, the display apparatus may include a cover layer including a first cover portion covering a top surface and side surfaces of the metal pattern layer and a second cover portion arranged in the groove.

In an embodiment, the cover layer may include a same material as a material of the subpixel electrode.

In an embodiment, the metal pattern layer may include a first sublayer, a second sublayer, and a third sublayer, that are sequentially stacked. The third sublayer may extend from a point where a side surface of the second sublayer meets a bottom surface of the third sub layer towards a center of the groove.

In an embodiment, the intermediate layer may include at least one organic material layer, and the at least one organic material layer and the counter electrode may be cut off from each other by the first separator in the third area.

According to an embodiment, a method of manufacturing a display apparatus includes preparing a substrate including a first area, a second area surrounding at least a portion of the first area, and a third area between the first area and the second area. An organic pattern layer is formed in the third area. A metal pattern layer is formed on the organic pattern layer. A first separator including a groove and a tip is formed by removing a portion of the organic pattern layer. In the second area, a light-emitting diode including a subpixel electrode, a counter electrode, and an intermediate layer between the subpixel electrode and the counter electrode is formed. In a cross-section, a top surface of the organic pattern layer comprises a first point having a greatest vertical distance from a top surface of the substrate. The metal pattern layer includes the tip extending towards a center of the groove. An imaginary line passing through the first point of the organic pattern layer and an edge of the tip of the metal pattern layer has a declined slope extending in a direction towards the top surface of the substrate.

In an embodiment, the forming of the organic pattern layer may include forming a preliminary-organic pattern layer on the substrate, disposing a mask on the preliminary-organic pattern layer, and exposing and developing the preliminary organic pattern layer by using the mask.

In an embodiment, the forming of the organic pattern layer may be performed by using a phase shift mask.

In an embodiment, the forming of the organic pattern layer may be performed by using a half-tone mask or a slit.

In an embodiment, the organic pattern layer may include a center portion and an edge portion, and a vertical distance from a top surface of the substrate to a top surface of the center portion may be less than a vertical distance from the top surface of the substrate to a top surface of the edge portion.

In an embodiment, the forming of the metal pattern layer may include forming a preliminary-metal pattern layer and forming a metal pattern layer including an opening by patterning the preliminary-metal pattern layer, and the opening in the metal pattern layer may expose at least a portion of the center portion of the organic pattern layer.

In an embodiment, the removing of the portion of the organic pattern layer may include ashing the organic pattern layer by using the metal pattern layer as a mask.

In an embodiment, the method may further include forming, on the metal pattern layer, a cover layer including a material same as a material of the subpixel electrode.

In an embodiment, the method may further include forming, in the substrate, an opening area overlapping the first area.

According to an embodiment, an electronic device includes the display apparatus.

In an embodiment, the electronic device may be at least one of a television, a notebook, a monitor, a billboard chart, an Internet of Things (IOT), a mobile phone, a smart phone, a tablet personal computer, a mobile communication terminal, an electronic organizer, an electronic book, a portable multimedia player, a navigation device, an ultra-mobile personal computer, a smart watch, a watch phone, or a head mounted display.

### BRIEF DESCRIPTION OF THE DRAWINGS

The above and other aspects, features, and advantages of certain non-limiting embodiments of the present disclosure will be more apparent from the following description taken in conjunction with the accompanying drawings, in which:
FIG. 1 is a perspective view schematically illustrating an electronic device according to an embodiment of the present disclosure;
FIG. 2 is a cross-sectional view briefly illustrating an electronic device, taken along a line I-I' shown in FIG. 1, according to an embodiment of the present disclosure;
FIG. 3 is a top-plan view schematically illustrating a display apparatus according to an embodiment of the present disclosure;
FIGS. 4 and 5 are equivalent circuit diagrams each briefly illustrating any one subpixel included in a display apparatus according to embodiments of the present disclosure;
FIG. 6 is a top plan view of a portion of a display apparatus according to an embodiment of the present disclosure;
FIG. 7 is a cross-sectional view illustrating a portion of a display apparatus, taken along a line III-III' shown in FIG. 6, according to an embodiment of the present disclosure;
FIG. 8 is a cross-sectional view of a portion of a display apparatus according to an embodiment of the present disclosure;
FIGS. 9A and 9B are cross-sectional views of portions of a display apparatus according to embodiments of the present disclosure;
FIGS. 10A, 10B, and 11 are cross-sectional views of portions of a display apparatus according to embodiments of the present disclosure;
FIGS. 12A to 12G are cross-sectional views briefly illustrating a method of manufacturing a display apparatus, according to embodiments of the present disclosure;
FIGS. 13A to 13D are cross-sectional views briefly illustrating a method of manufacturing a display apparatus, according to embodiments of the present disclosure;
FIGS. 14A to 14C are cross-sectional views briefly illustrating a method of manufacturing a display apparatus, according to embodiments of the present disclosure;
FIG. 15 is a cross-sectional view of a portion of a display apparatus according to an embodiment of the present disclosure;
FIG. 16 is a cross-sectional view of a portion of a display apparatus according to an embodiment of the present disclosure;
FIGS. 17A to 17E are cross-sectional views briefly illustrating a method of manufacturing a display apparatus, according to embodiments of the present disclosure; and
FIGS. 18A to 18C are cross-sectional views briefly illustrating a method of manufacturing a display apparatus, according to embodiments of the present disclosure.

### DETAILED DESCRIPTION OF EMBODIMENTS

Reference will now be made in detail to embodiments, examples of which are illustrated in the accompanying drawings, wherein like reference numerals refer to like elements throughout. In this regard, embodiments of the present disclosure may have different forms and should not be construed as being limited to the descriptions set forth herein. Accordingly, non-limiting embodiments are merely described below, by referring to the figures, to explain aspects of the present disclosure. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As used herein, the terms 'first' and 'second' are only used to distinguish one element from others, and are not used in a limiting sense.

As used herein, the singular forms are intended to encompass the plural forms as well, unless the context clearly indicates otherwise.

It will be further understood that the terms "comprise," "comprising," "include," "including," "have," "having," and the like, when used herein, specify the presence of stated features and/or elements, but do not preclude the presence or addition of one or more other features and/or elements.

In the following embodiments, when a portion such as a film, an area, or a component is on or above another portion, the portion may be directly on the other portion, or other films, areas, or components may be located therebetween.

In the drawings, the sizes of elements may be exaggerated or reduced for convenience. For example, since the size and thickness of each element may be arbitrarily shown in the drawings for convenience of description, embodiments of the present disclosure are not necessarily limited to those illustrated.

When some embodiments may be differently implemented, a particular process sequence may be performed differently from a sequence described. For example, two processes described in succession may be performed substantially simultaneously, or may be performed in an order opposite to an order described.

In the present specification, 'A and/or B' indicates A, B, or A and B. 'At least one of A or B' indicates A, B, or A and B.

In the present specification, when it is referred that a film, an area, and a component are connected to another film, area, and component, the film, area, and component may be directly connected to the other film, area, and component, or may be indirectly connected with another film, area, and component therebetween. For example, when it is referred that a film, an area, and a component are electrically connected to another film, area, and component, the film, area, and component may be directly in electric connection with the other film, area, and component, or may be indirectly in electric connection with the other film, area, and component with another film, area, and component therebetween.

An x-axis, a y-axis, and a z-axis are not necessarily limited to three axes on an orthogonal coordinate system, and may be interpreted as a wider meaning including the same. For example, the x-axis, y-axis, and z-axis may be orthogonal to one another, but may also refer to different directions that cross each other but are not orthogonal to one another.

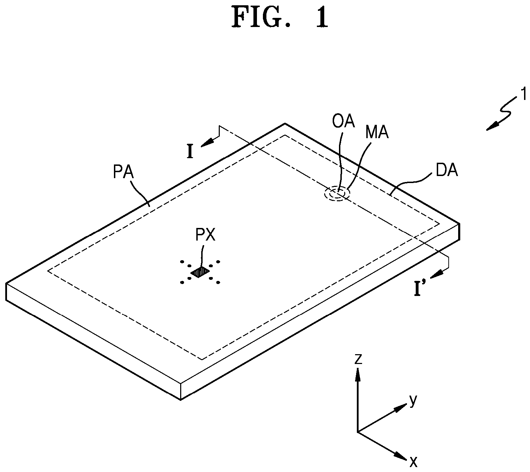

FIG. 1 is a perspective view schematically illustrating an electronic device 1 according to an embodiment.

Referring to FIG. 1, the electronic device 1 may include a display apparatus, which is an apparatus configured to display videos and/or still images. In an embodiment, the display apparatus may be used for display screens of various products such as televisions, notebooks, monitors, billboard charts, Internet of Things (IOT), and the like, as well as mobile electronic devices such as mobile phones, smart phones, tablet personal computers (tablet PCs), mobile communication terminals, electronic organizers, electronic books, portable multimedia players (PMP), navigation devices, Ultra Mobile PCs (UMPC), and the like. In addition, the display apparatus according to an embodiment may be used as a display screen for wearable devices such as smart watches, watch phones, and head mounted displays (HMD). In addition, the display apparatus according to an embodiment may be used as dashboards of vehicles, center information displays (CID) arranged on center fasciae or dashboards of vehicles, room mirror displays substituting for side mirrors of vehicles, entertainment for rear seats of vehicles, and displays arranged on rear surfaces of front sheets. For convenience of explanation, FIG. 1 illustrates that the electronic device 1 according to an embodiment is a smart phone. However, embodiments of the present disclosure are not necessarily limited thereto.

In an embodiment, in a plan view (e.g., in a plane defined in the x and y directions), the electronic device 1 may have the form of a rectangle. For example, the electronic device 1 may have the form of a rectangular plane surface having a short axis in an x direction and a long axis in a y direction, as shown in FIG. 1. A corner at which the short axis in the x direction meets the long axis in the y direction may be rounded to have a certain curvature or may be formed in a square shape. However, the planar shape of the electronic device 1 is not necessarily limited to a rectangle, and may be formed into other polygons, oval shapes, or amorphous shapes.

The electronic device 1 may include an opening area OA and a display area DA surrounding at least a portion of the opening area OA (e.g., in the x and/or y directions). The electronic device 1 may include a middle area MA between the opening area OA and the display area DA; and a peripheral area PA surrounding the outside of the display area DA (e.g., in the x and/ory directions). In an embodiment, the middle area MA may have a closed-loop shape entirely surrounding the opening area OA (e.g., in the x and y directions) in a plan view.

The opening area OA may be inside the display area DA. In an embodiment, as illustrated in FIG. 1, the opening area OA may be in the middle (e.g., in the x direction) of an upper side (e.g., in the y direction) of the display area DA. Alternatively, the display area DA may be variously arranged, such as at a left-upper side of the display area DA or a right-upper side of the display area DA. Although FIG. 1 illustrates that the opening area OA is arranged in a singularity (e.g., only one opening area OA is disposed in the electronic device 1), embodiments of the present disclosure are not necessarily limited thereto and the electronic device 1 may include a plurality of opening areas OA in some embodiments.

In an embodiment, the opening area OA may include a first area, the display area DA may include a second area, and a middle area MA may include a third area.

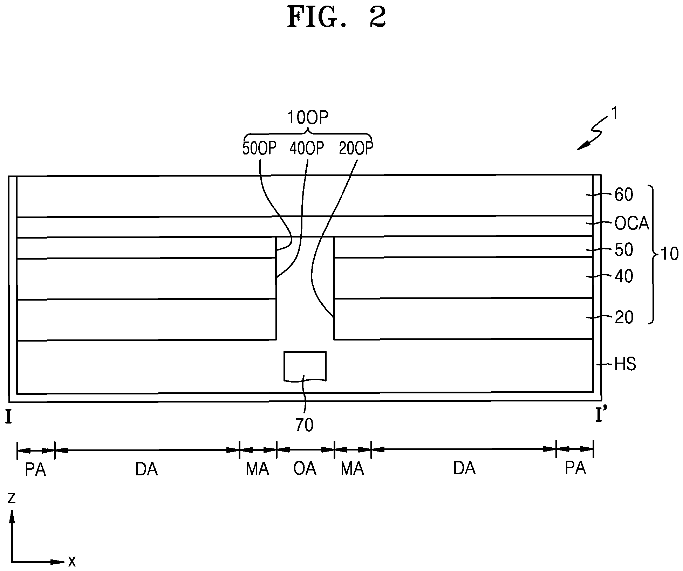

FIG. 2 is a cross-sectional view briefly illustrating the electronic device 1 according to an embodiment, taken along a line I-I' shown in FIG. 1.

Referring to FIG. 2, the electronic device 1 may include a display apparatus 10 and a component 70 arranged in an opening area OA of the display apparatus 10. In an embodiment, the display apparatus 10 and the component 70 may be accommodated in a housing HS.

In an embodiment, the display apparatus 10 may include an image-generating layer 20, an input-sensing layer 40, an optical function layer 50, and a cover window 60 (e.g., arranged in a z direction).

The image-generating layer 20 may include display elements configured to emit light to display images. In an embodiment, the display elements may include light-emitting diodes, such as organic light-emitting diodes including organic emission layers. In some embodiments, the light-emitting diodes may include inorganic light-emitting diodes including inorganic materials. The inorganic light-emitting diodes may include a PN junction diode including inorganic semiconductor-based materials. Holes and electrons are injected when a voltage is applied in a positive direction to the PN junction diode, and light having certain colors may be emitted by converting energy, which is generated by recombination of the holes and electrons, into light energy. The aforementioned inorganic light-emitting diode may have a width from several micrometers to several hundreds of micrometers or from several nanometers to several hundreds of nanometers. In some embodiments, the image-generating layer 20 may include quantum-dot light-emitting diodes. For example, an emission layer of the image-generating layer 20 may include an organic material, may include an inorganic material, may include quantum dots, may include an organic material and quantum dots, or may include an inorganic material and quantum dots.

The input-sensing layer 40 may include coordinate information according to external inputs, such as touch events. The input-sensing layer 40 may include a touch electrode (or referred to as a sensing electrode) and trace lines connected to the touch electrode. The input-sensing layer 40 may be disposed on the image-generating layer 20. The input-sensing layer 40 may be configured to sense external inputs in mutual capacitance method and/or a self-capacitance method.

The input-sensing layer 40 may be directly disposed on the image-generating layer 20, or may be separately formed and then bonded onto the image-generating layer 20 through an adhesive layer such as an optical clear adhesive (OCA). For example, in an embodiment the input-sensing layer 40 may be consecutively formed after a process of forming the image-generating layer 20, and in this embodiment, the adhesion layer may be not disposed between the input-sensing layer 40 and the image-generating layer 20 (e.g., in the z direction). Although FIG. 2 illustrates that the input-sensing layer 40 is between the image-generating layer 20 and the optical function layer 50 (e.g., in the z direction), in some embodiments, the input-sensing layer 40 may be disposed above the optical function layer 50 and the optical function layer 50 may be disposed between the image-generating layer 20 and the input-sensing layer 40 (e.g., in the z direction).

The optical function layer 50 may include an anti-reflection layer. The anti-reflection layer may be configured to reduce reflectivity of light (e.g., external light) incident to the display apparatus 10 from outside (e.g., the external environment) through the cover window 60. In an embodiment, the anti-reflection layer may include a retarder and a polarizer. However, embodiments of the present disclosure are not necessarily limited thereto. In some embodiments, the anti-reflection layer may include a black matrix and color filters. The color filters may be arranged in consideration of colors of light emitted from each of the light-emitting diodes in the image-generating layer 20.

To increase transmissivity of the opening area OA, the display apparatus 10 may include an opening 10OP penetrating some of layers included in the display apparatus 10. The opening 10OP may include a first opening 20OP, a second opening 40OP, and a third opening 50OP respectively penetrating the image-generating layer 20, the input-sensing layer 40, and the optical function layer 50 (e.g., in the z direction). The first opening 20OP in the image-generating layer 20, the second opening 40OP in the input-sensing layer 40, and the third opening 50OP in the optical function layer 50 may overlap one another to form the opening 10OP of the display apparatus 10.

The cover window 60 may be disposed on the optical function layer 50. In an embodiment, the cover window 60 may be bonded to the optical function layer 50 through an adhesion layer such as an optical clear adhesive OCA disposed between the cover window 60 and the optical function layer 50 (e.g., in the z direction). The cover window 60 may cover the first opening 20OP in the image-generating layer 20, the second opening 40OP in the input-sensing layer 40, and the third opening 50OP in the optical function layer 50.

The cover window 60 may include glass or plastic. In an embodiment, the glass may include Ultra-thin glass. The plastic may include polyether sulfone, polyacrylate, polyether imide, polyethylene naphthalate, polyethylene terephthalate, polyphenylene sulfide, polyarylate, polyimide, polycarbonate, cellulose acetate propionate, or the like.

The opening area OA may include a kind of component area (e.g., a sensor area, a camera area, a speaker area, or the like) in which the component 70 to add various functions to the electronic device 1 is arranged.

The component 70 may include an electronic component. For example, in an embodiment the component 70 may include an electronic component in which light or sound is used. For example, the electronic component may include a sensor configured to use light, such as an infrared-ray sensor, a camera configured to receive light and capture images, a sensor configured to measure distances or recognize fingerprints by outputting and sensing light or sound, a small-sized lamp configured to output light, a speaker configured to output sound, and the like. The electronic component configured to use light may use light of various wavelength bands, such as visible light, infrared light, ultraviolet light, and the like. The opening area OA corresponds to an area through which light or/and sound output outside from the component 70 or proceeding towards the electronic component from the outside (e.g., the external environment) may be transmitted.

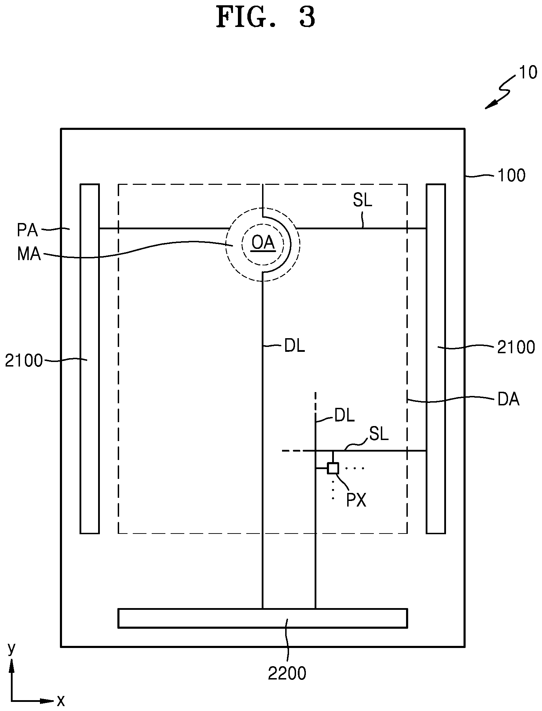

FIG. 3 is a top-plan view schematically illustrating the display apparatus 10 according to an embodiment.

Referring to FIG. 3, the display apparatus 10 may include a plurality of subpixels PX arranged in the display area DA, and may be configured to display images using light emitted from each of the plurality of subpixels PX. In an embodiment, each of the plurality of subpixels PX may be configured to emit red, green, or blue light using the light-emitting diode. However, embodiments of the present disclosure are not necessarily limited thereto and the colors of light emitted by the plurality of subpixels PX may vary. The light-emitting diode of each of the plurality of subpixels PX may be electrically connected to a scan line SL and a data line DL.

In an embodiment, scan drivers 2100 configured to provide a scan signal to each of the subpixels PX, a data driver 2200 configured to provide a data signal to each of the subpixels PX, a first main power wiring configured to provide a first power voltage (e.g., a driving voltage), and a second main power wiring configured to provide a second power voltage (e.g., a common voltage) may be arranged in the peripheral area PA. In an embodiment, the scan drivers 2100 may be respectively arranged at two sides of the display area DA, with the display area DA therebetween (e.g., in the x direction). In this embodiment, a subpixel PX arranged on the left of the opening area OA may be connected to the scan driver 2100 arranged on the left of the display area DA, and a subpixel PX arranged on the right of the opening area OA may be connected to the scan driver 2100 arranged on the right of the display area DA.

The middle area MA may surround the opening area OA. The middle area MA indicates an area in which display elements such as light-emitting diodes configured to emit light are not arranged. Signal lines configured to provide signals to the subpixels PX provided near the opening area OA may pass over the middle area MA. For example, the data lines DL and/or the scan lines SL may cross the display area DA, and some of the data lines DL and/or the scan lines SL may bypass in the middle area MA along an edge of the opening 10OP of the display apparatus 10 formed in the opening area OA. In an embodiment, FIG. 3 illustrates that the data lines DL cross the display area DA in the y direction and some of the data lines DL bypass in the middle area MA to partially surround the opening area OA. In an embodiment, the scan lines SL may cross the display area DA in the x direction and may be spaced apart from one another with the opening area OA therebetween.

Although FIG. 3 illustrates that the data driver 2200 is arranged adjacent to a side of the substrate 100 (e.g., a lower side in the y direction), embodiments of the present disclosure are not necessarily limited thereto. For example, in an embodiment, the data driver 2200 may be disposed on a printed circuit board electrically connected to a pad arranged on a side of the display apparatus 10. The printed circuit board may be flexible, and a portion of the printed circuit board may be curved to be under a back surface of the substrate 100.

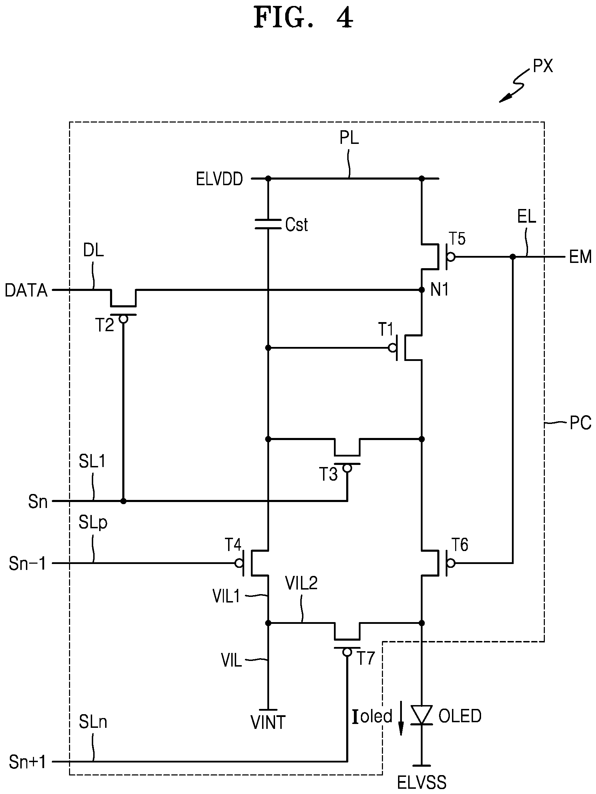

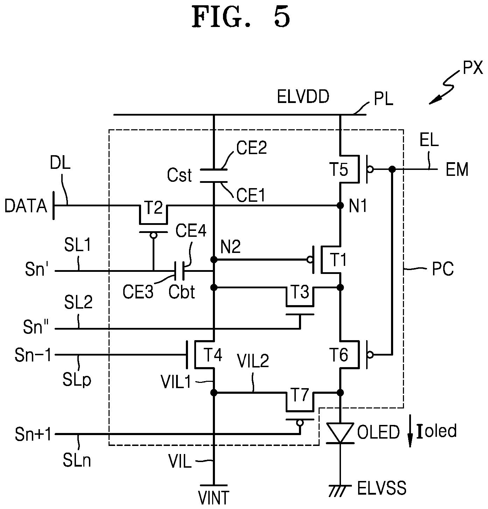

FIGS. 4 and 5 are equivalent circuit diagrams of any one subpixel PX included in the display apparatus 10 according to embodiments.

Referring to FIG. 4, a subpixel PX may include a subpixel circuit PC and an organic light-emitting diode OLED, such as a display element electrically connected to the subpixel circuit PC.

For example, in an embodiment the subpixel circuit PC may include a first thin-film transistor T1, a second thin-film transistor T2, a third thin-film transistor T3, a fourth thin-film transistor T4, a fifth thin-film transistor T5, a sixth thin-film transistor T6, a seventh thin-film transistor T7, and a capacitor Cst. However, embodiments of the present disclosure are not necessarily limited thereto and the number of the thin-film transistors in the subpixel circuit PC may vary.

In an embodiment, the first thin-film transistor T1 may include a driving transistor, the second thin-film transistor T2 may include a switching transistor, the third thin-film transistor T3 may include a compensation transistor, the fourth thin-film transistor T4 may include a first initialization transistor, the fifth thin-film transistor T5 may include an operation control transistor, the sixth thin-film transistor T6 may include an emission control transistor, and the seventh thin-film transistor T7 may include a second initialization transistor.

The organic light-emitting diode OLED may include a subpixel electrode and a counter electrode. The subpixel electrode of the organic light-emitting diode OLED may be connected to the first thin-film transistor T1 through the sixth thin-film transistor T6 and may receive a driving current loled, and the counter electrode may receive a common voltage ELVSS. The organic light-emitting diode OLED may be configured to generate light having luminance corresponding to the driving current loled.

In an embodiment, all of the first thin-film transistor T1 to the seventh thin-film transistor T7 may include PMOS transistors. In an embodiment, the first thin-film transistor T1 to the seventh thin-film transistor T7 may include amorphous silicon or polycrystalline silicon.

The signal lines may include a first scan line SL1, a previous scan line SLp, a next scan line SLn, an emission control line EL, and the data line DL. However, embodiments of the present disclosure are not necessarily limited thereto. In addition, the first scan line SL1 may be configured to deliver a first scan signal Sn. The previous scan line SLp may be configured to deliver a previous scan signal Sn-1 to the fourth thin-film transistor T4. The next scan line SLn may be configured to deliver a next scan signal Sn+1 to the seventh thin-film transistor T7. The emission control line EL may be configured to deliver an emission control signal EM to the fifth thin-film transistor T5 and the sixth thin-film transistor T6. The data line DL may be configured to transmit a data signal DATA.

A driving voltage line PL may be configured to deliver a driving voltage ELVDD to the first thin-film transistor T1, and an initialization voltage line VIL may be configured to deliver an initialization voltage VINT, which initializes the first thin-film transistor T1 and the organic light-emitting diode OLED, to the subpixel PX. For example, in an embodiment a first initialization voltage line VIL1 may be configured to deliver the initialization voltage VINT to the fourth thin-film transistor T4, and a second initialization voltage line VIL2 may be configured to deliver the initialization voltage VINT to the seventh thin-film transistor T7.

A gate electrode of the first thin-film transistor T1 may be connected to the capacitor Cst. Any one of a source area and a drain area of the first thin-film transistor T1 may be connected to the driving voltage line PL via the fifth thin-film transistor T5 through a first node N1, and the other one of the source area and the drain area of the first thin-film transistor T1 may be electrically connected to the subpixel electrode of the organic light-emitting diode OLED via the sixth thin-film transistor T6. The first thin-film transistor T1 may be configured to receive the data signal DATA in response to a switching operation of the second thin-film transistor T2 and provide the driving current loled to the organic light-emitting diode OLED.

A gate electrode of the second thin-film transistor T2 may be connected to the first scan line SL1 configured to deliver the first scan signal Sn. One of a source area and a drain area of the second thin-film transistor T2 may be connected to the data line DL, and the other one of the source area and the drain area of the second thin-film transistor T2 may be connected to the first thin-film transistor T1 through the first node N1 and connected to the driving voltage line PL via the fifth thin-film transistor T5. In an embodiment, the second thin-film transistor T2 may be turned on in response to the first scan signal Sn delivered through the first scan line SL1 and perform a switching operation to deliver the data signal DATA, which is delivered from the data line DL, to the first thin-film transistor T1 through the first node N1.

A gate electrode of the third thin-film transistor T3 may be connected to the first scan line SL1. One of a source area and a drain area of the third thin-film transistor T3 may be connected to the subpixel electrode of the organic light-emitting diode OLED via the sixth thin-film transistor T6. The other one of the source area and the drain area of the third thin-film transistor T3 may be connected to the capacitor Cst and the gate electrode of the first thin-film transistor T1. In an embodiment, the third thin-film transistor T3 may be turned on in response to the first scan signal Sn delivered through the first scan line SL1 and have the first thin-film transistor T1 diode-connected.

A gate electrode of the fourth thin-film transistor T4 may be connected to the previous scan line SLp. One of a source area and a drain area of the fourth thin-film transistor T4 may be connected to the first initialization voltage line VIL1. The other one of the source area and the drain area of the fourth thin-film transistor T4 may be connected to a first capacitor electrode CE1 of the capacitor Cst and the gate electrode of the first thin-film transistor T1. In an embodiment, the fourth thin-film transistor T4 may be turned on in response to the previous scan signal Sn-1 delivered through the previous scan line SLp and perform an initialization operation to initialize a voltage of the gate electrode of the first thin-film transistor T1 by delivering the initialization voltage VINT to the gate electrode of the first thin-film transistor T1.

A gate electrode of the fifth thin-film transistor T5 may be connected to the emission control line EL, one of a source area and a drain area of the fifth thin-film transistor T5 may be connected to the driving voltage line PL, and the other one of the source area and the drain area of the fifth thin-film transistor T5 may be connected to the first thin-film transistor T1 and the second thin-film transistor T2 through the first node N1.

A gate electrode of the sixth thin-film transistor T6 may be connected to the emission control line EL. One of a source area and a drain area of the sixth thin-film transistor T6 may be connected to the first thin-film transistor T1 and the third thin-film transistor T3, and the other one of the source area and the drain area of the sixth thin-film transistor T6 may be electrically connected to the subpixel electrode of the organic light-emitting diode OLED.

In an embodiment, the fifth thin-film transistor T5 and the sixth thin-film transistor T6 may be simultaneously turned on in response to the emission control signal EM delivered through the emission control line EL, such that the driving voltage ELVDD is delivered to the organic light-emitting diode OLED and the driving current loled flows through the organic light-emitting diode OLED.

A gate electrode of the seventh thin-film transistor T7 may be connected to the next scan line SLn. One of a source area and a drain area of the seventh thin-film transistor T7 may be connected to the subpixel electrode of the organic light-emitting diode OLED, and the other one of the source area and the drain area of the seventh thin-film transistor T7 may be connected to the second initialization voltage line VIL2 and receive the initialization voltage VINT. In an embodiment, the seventh thin-film transistor T7 may be turned on in response to the next scan signal Sn+1 delivered through the next scan line SLn and initialize the subpixel electrode of the organic light-emitting diode OLED. In an embodiment, the next scan line SLn may be identical to the first scan line SL1. In this embodiment, the scan line may be configured to deliver a same electric signal at a certain time interval, and thus may function as both the first scan line SL1 and the next scan line SLn. In some embodiments, the seventh thin-film transistor T7 may be omitted.

The capacitor Cst may be configured to maintain a voltage applied to the gate electrode of the first thin-film transistor T1 by being connected to the driving voltage line PL and the gate electrode of the first thin-film transistor T1 and storing and maintaining a voltage corresponding to a difference between voltages at two ends of the capacitor Cst.

Details of operations of the subpixel circuit PC and the organic light-emitting diode OLED as the display element, according to an embodiment, are as follows.

In an initialization period, when the previous scan signal Sn-1 is provided through the previous scan line SLp, the fourth thin-film transistor T4 is turned on to correspond to the previous scan signal Sn-1, and the first thin-film transistor T1 may be initialized due to the initialization voltage VINT provided from the first initialization voltage line VIL1.

In an embodiment, in a data programming period, when the first scan signal Sn is provided through the first scan line SL1, the second thin-film transistor T2 and the third thin-film transistor T3 may be turned on to correspond to the first scan signal Sn. In this embodiment, the first thin-film transistor T1 may be diode-connected by the third thin-film transistor T3 that is turned on, and may be biased in a positive direction. By doing so, a compensation voltage DATA+Vth (where Vth is a negative value), which decreased by a threshold voltage Vth of the first thin-film transistor T1 from the data signal DATA provided from the data line DL, may be applied to the gate electrode of the first thin-film transistor T1. The driving voltage ELVDD and the compensation voltage DATA+Vth may be applied to two ends of the capacitor Cst, and a load corresponding to the difference between the voltages at two ends of the capacitor Cst may be stored in the capacitor Cst.

In an embodiment, in an emission period, the fifth thin-film transistor T5 and the sixth thin-film transistor T6 may be turned on in response to the emission control signal EM provided from the emission control line EL. A driving current corresponding to a voltage difference between a voltage of the gate electrode of the first thin-film transistor T1 and the driving voltage ELVDD is generated, and the driving current loled may be provided to the organic light-emitting diode OLED through the sixth thin-film transistor T6.

Referring to FIG. 5, in an embodiment the subpixel circuit PC of the subpixel SP may include the first thin-film transistor T1 to the seventh thin-film transistor T7, a first capacitor Cst, a second capacitor Cbt, and the organic light-emitting diode OLED as a display element.

In an embodiment, some of the first thin-film transistor T1 to the seventh thin-film transistor T7 may include n-channel MOSFET (NMOS) transistors, and others of the first thin-film transistor T1 to the seventh thin-film transistor T7 may include p-channel MOSFET (PMOS) transistors. For example, as shown in FIG. 5, among the first thin-film transistor T1 to the seventh thin-film transistor T7, the third thin-film transistor T3 and the fourth thin-film transistor T4 may include NMOS transistors, and the first thin-film transistor T1, the second thin-film transistor T2, the fifth thin-film transistor T5, the sixth thin-film transistor T6 and the seventh thin-film transistor T7 may include PMOS transistors. Alternatively, among the first thin-film transistor T1 to the seventh thin-film transistor T7, the third thin-film transistor T3, the fourth thin-film transistor T4, and the seventh thin-film transistor T7 may include NMOS transistors, and the first thin-film transistor T1, the second thin-film transistor T2, the fifth thin-film transistor T5 and the sixth thin-film transistor T6 may include PMOS transistors. Alternatively, all of the first thin-film transistors T1 to the seventh thin-film transistors T7 may include NMOS transistors.

The signal lines may include the first scan line SL1 configured to deliver a first scan signal Sn', a second scan line SL2 configured to deliver a second scan signal Sn", the previous scan line SLp configured to deliver the previous scan signal Sn-1 to the fourth thin-film transistor T4, the emission control line EL configured to deliver the emission control signal EM to the fifth thin-film transistor T5 and the sixth thin-film transistor T6, the next scan line SLn configured to deliver the next scan signal Sn+1 to the seventh thin-film transistor T7, and the data line DL configured to deliver the data signal DATA.

The first thin-film transistor T1 may be connected to the driving voltage line PL via the fifth thin-film transistor T5, and may be electrically connected to the organic light-emitting diode OLED via the sixth thin-film transistor T6. In an embodiment, the first thin-film transistor T1 may be configured to receive the data signal DATA in response to the switching operation of the second thin-film transistor T2 and provide the driving current loled to the organic light-emitting diode OLED.

The second thin-film transistor T2 may be connected to the first scan line SL1 and the data line DL, and may be connected to the driving voltage line PL via the fifth thin-film transistor T5. In an embodiment, the second thin-film transistor T2 may be turned on in response to the first scan signal Sn' delivered through the first scan line SL1 and perform the switching operation to deliver the data signal DATA, which is delivered from the data line DL, to the first node N1.

The third thin-film transistor T3 may be connected to the second scan line SL2, and may be connected to the organic light-emitting diode OLED via the sixth thin-film transistor T6. In an embodiment, the third thin-film transistor T3 may be configured to compensate for the threshold voltage of the first thin-film transistor T1 by being turned on by the second scan signal Sn" delivered from the second scan line SL2 and having the first thin-film transistor T1 diode-connected.

The fourth thin-film transistor T4 may be connected to the previous scan line SLp and the first initialization voltage line VIL1. In an embodiment, the fourth thin-film transistor T4 may be turned on in response to the previous scan signal Sn-1 delivered through the previous scan line SLp, and may initialize the voltage of the gate electrode of the first initialization voltage line VIL1 by delivering the initialization voltage VINT, which is delivered from the first initialization voltage line VIL1, to the gate electrode of the first thin-film transistor T1.

In an embodiment, the fifth thin-film transistor T5 and the sixth thin-film transistor T6 may be connected to the emission control line EL, may be simultaneously turned on in response to the emission control signal EM delivered from the emission control signal EM, and may form a current path such that the driving current loled may flow from the driving voltage line PL in a direction towards the organic light-emitting diode OLED.

The seventh thin-film transistor T7 may be connected to the next scan line SLn and the second initialization voltage line VIL2. In an embodiment, the seventh thin-film transistor T7 may be turned on in response to the next scan signal Sn+1 delivered through the next scan line SLn, and may deliver the initialization voltage VINT from the second initialization voltage line VIL2 to the organic light-emitting diode OLED to initialize the organic light-emitting diode OLED. However, embodiments of the present disclosure are not necessarily limited thereto. For example, in some embodiments the seventh thin-film transistor T7 may be omitted.

The first capacitor Cst includes the first capacitor electrode CE1 and a second capacitor electrode CE2. The first capacitor electrode CE1 may be connected to the gate electrode of the first thin-film transistor T1, and the second capacitor electrode CE2 may be connected to the driving voltage line PL. In an embodiment, the first capacitor Cst may be configured to maintain the voltage applied to the gate electrode of the first thin-film transistor T1 by storing and maintaining the voltage corresponding to a difference between a voltage of the driving voltage line PL and a voltage at both ends of the gate electrode of the first thin-film transistor T1.

The second capacitor Cbt may include a third capacitor electrode CE3 and a fourth capacitor electrode CE4. The third capacitor electrode CE3 may be connected to the first scan line SL1 and the gate electrode of the second thin-film transistor T2. The fourth capacitor electrode CE4 may be connected to the gate electrode of the first thin-film transistor T1 and the first capacitor electrode CE1 of the first capacitor Cst. In an embodiment, the second capacitor Cbt may be a boosting capacitor that boosts a voltage of the second node N2 and clearly express a black gray scale when the first scan signal Sn' of the first scan line SL1 is a voltage to turn-off the second thin-film transistor T2.

In an embodiment, at least one of the first thin-film transistor T1 to the seventh thin-film transistorT7 may include a semiconductor layer including an oxide, and others may include a semiconductor layer including amorphous silicon or polycrystalline silicon.

For example, in an embodiment the first thin-film transistor T1, which is a driving transistor having direct influence on luminance of the display apparatus 10, is arranged to include a semiconductor layer including polycrystalline silicon having high reliability, and by doing so, the display apparatus having high resolution may be implemented.

As an oxide semiconductor has high carrier mobility and a low leakage current, voltage drop of the oxide semiconductor may be not significant even when the oxide semiconductor is driven for a long period of time. For example, the oxide semiconductor may be driven at a low frequency, because color change in images due to the voltage drop is not significant even when the oxide semiconductor is driven at a low frequency.

The oxide semiconductor has an advantage of a small leakage current. Therefore, by employing an oxide semiconductor for any one of the third thin-film transistor T3 and the fourth thin-film transistor T4 connected to the gate electrode of the first thin-film transistor T1, power consumption may be reduced while preventing a leakage current that is likely flow to the gate electrode of the first thin-film transistor T1.

The subpixel circuit PC is not necessarily limited to the numbers and circuit designs of the thin-film transistors and the capacitors described with reference to FIGS. 4 and 5, and the number and the circuit design thereof may be variously modified.

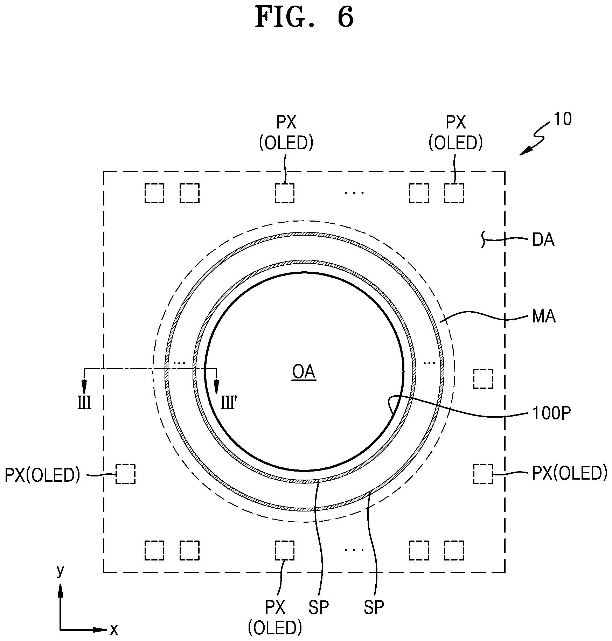

FIG. 6 is a top-plan view of a portion of the display apparatus 10 according to an embodiment.

FIG. 6 illustrates the opening area OA, the middle area MA, and the display area DA of the display apparatus 10. The subpixels PX may be arranged in the display area DA. The subpixels PX may be arranged in the display area DA to surround the opening area OA and the middle area MA (e.g., in the x and/or y directions). The subpixels PX may include a minimum area through which light is emitted, and the light may be emitted through the display element, such as the light-emitting diode. A position of the subpixel PX may correspond to a position of the light-emitting diode. A description that the subpixel PX is arranged in the display area DA may indicate that the light-emitting diode is arranged in the display area DA.

The subpixels PX and/or light-emitting diodes adjacent to the opening area OA may be arranged to be spaced apart from one another about the opening area OA in a plan view. For example, in an embodiment, in a plan view, the subpixels PX and/or the light-emitting diodes may be arranged to be vertically spaced apart from one another around the opening area OA (e.g., in the y direction), or may be arranged to be horizontally spaced apart from one another around the opening area OA (e.g., in the x direction).

In an embodiment, separators SP may be arranged to be spaced apart from each other in the middle area MA. For example, the separators SP may be arranged to be spaced apart from each other between the display area DA and the opening area OA or between the display area DA and the opening 10OP. In an embodiment, each of the separators SP may have a closed-loop shape in a plan view (e.g., when viewed from a direction perpendicular to a top surface of the substrate, such as the z direction).

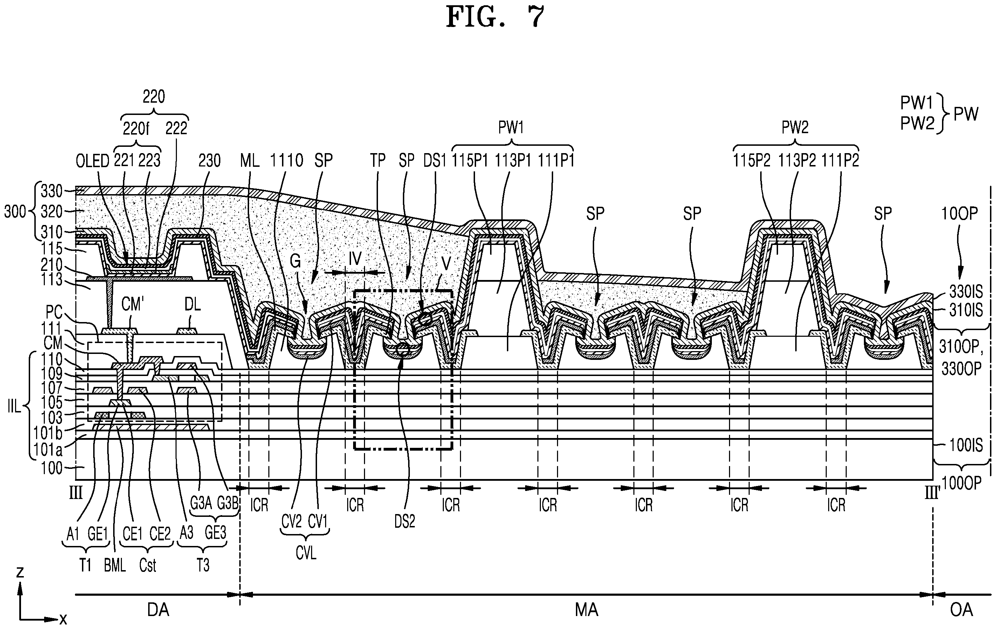

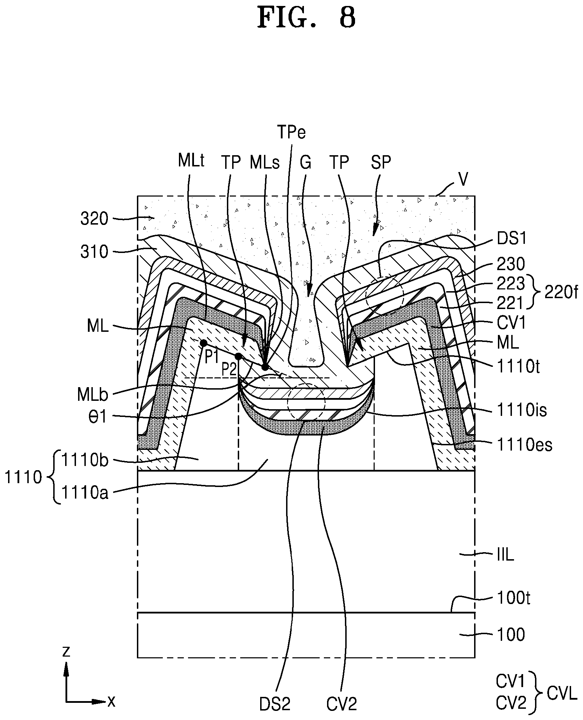

FIG. 7 is a cross-sectional view illustrating a portion of the display apparatus 10 according to an embodiment, taken along a line III-III' shown in FIG. 6. FIG. 8 is a cross-sectional view of a portion of the display apparatus 10 according to an embodiment, which illustrates a portion V shown in FIG. 7.

Referring to the display area DA in FIG. 7, FIG. 7 illustrates the image-generating layer 20 of the display apparatus 10. In an embodiment, the image-generating layer 20 may include a substrate 100, a circuit-diode layer including the subpixel circuit PC and the organic light-emitting diode OLED disposed on the substrate 100, and an encapsulation layer 300.

The circuit-diode layer may include the subpixel circuit PC and a plurality of insulating layers disposed on or under components of the subpixel circuit PC (e.g., in the z direction). The insulating layers may include an inorganic insulating layer and an organic insulating layer. In an embodiment, the inorganic insulating layer IIL may include, for example, a first buffer layer 101a, a second buffer layer 101b, a first gate insulating layer 103, a first interlayer insulating layer 105, a second interlayer insulating layer 107, a second gate insulating layer 109, and a third interlayer insulating layer 110 (e.g., arranged in the z direction). In an embodiment, the organic insulating layer may include, for example, a first planarization layer 111 and a second planarization layer 113. However, embodiments of the present disclosure are not necessarily limited thereto.

The substrate 100 may include glass or a polymer resin. In an embodiment, the substrate 100 may have a structure in which a base layer including a polymer resin and a barrier including an inorganic insulator, such as silicon oxide or silicon nitride, are alternately stacked (e.g., in the z direction). In an embodiment, the polymer resin may include polyether sulfone, polyarylate, polyether imide, polyethylene naphthalate, polyethylene terephthalate, polyphenylene sulfide, polyimide, polycarbonate, cellulose triacetate, cellulose acetate propionate, or the like.

The subpixel circuit PC may be formed above the substrate 100, and a light-emitting diode, such as the organic light-emitting diode OLED, may be disposed on the subpixel circuit PC.

Before the subpixel circuit PC is formed, the first buffer layer 101a and the second buffer layer 101b to prevent permeation of impurities into the subpixel circuit PC may be formed on the substrate 100. In an embodiment, the first buffer layer 101a and the second buffer layer 101b may include an inorganic insulator such as silicon nitride, silicon oxynitride, and silicon oxide, and may include a single-layered or multi-layered structure including the aforementioned inorganic insulator.

A back metal layer BML may be disposed between the first buffer layer 101a and the second buffer layer 101b. The back metal layer BML may prevent external light from reaching the subpixel circuit PC. In an embodiment, the back metal layer BML may include, for example, a conductive material including molybdenum (Mo), aluminum (Al), copper (Cu), titanium (Ti), and the like, and may include a single-layered or multi-layered structure including the aforementioned materials.

The subpixel circuit PC may include the plurality of transistors and the capacitor, as described above with reference to FIG. 5. Regarding this, FIG. 7 illustrates the first thin-film transistor T1, the third thin-film transistor T3, and the capacitor Cst.

The first thin-film transistor T1 may include a semiconductor layer A1 (hereinafter, referred to as a first semiconductor layer) on the second buffer layer 101b (e.g., disposed directly thereon in the z direction) and a gate electrode GE1 (hereinafter, referred to as a first gate electrode) overlapping a channel area of the first semiconductor layer A1 (e.g., in the z direction). In an embodiment, the first semiconductor layer A1 may include a silicon-based semiconductor material, such as polysilicon. The first semiconductor layer A1 may include the channel area and impurity areas arranged at two sides of the channel area. One of the impurity areas may correspond to a source area, and the other one may correspond to a drain area.

The first gate insulating layer 103 may be disposed between the first semiconductor layer A1 and the first gate electrode GE1 (e.g., in the z direction). In an embodiment, the first gate insulating layer 103 may include an inorganic insulator such as silicon oxide, silicon nitride, and silicon oxynitride, and may include a single-layered or multi-layered structure including the aforementioned inorganic insulator.

In an embodiment, the first gate electrode GE1 may include a conductive material including Mo, Al, Cu, Tl, and the like, and may include a single-layered or multi-layered structure including the aforementioned materials.

In an embodiment, the capacitor Cst may include the first capacitor electrode CE1 and the second capacitor electrode CE2 overlapping each other (e.g., in the z direction). The second capacitor electrode CE2 may be disposed above the first capacitor electrode CE1. In an embodiment, the first capacitor electrode CE1 of the capacitor Cst may include the first gate electrode GE1. For example, the first gate electrode GE1 may include the first capacitor electrode CE1 of the capacitor Cst. For example, the first gate electrode GE1 and the first capacitor electrode CE1 of the capacitor Cst may be integrally formed.

The first interlayer insulating layer 105 may be disposed between the first capacitor electrode CE1 and the second capacitor electrode CE2 of the capacitor Cst (e.g., in the z direction). In an embodiment, the first interlayer insulating layer 105 may include an inorganic insulator such as silicon oxide, silicon nitride, silicon oxynitride, and the like, and may include a single-layered or multi-layered structure including the aforementioned inorganic insulator.

In an embodiment, the second capacitor electrode CE2 of the capacitor Cst may include a low-resistance conductive material such as Mo, Al, Cu, and/or Ti, and may include a single-layered or multi-layered structure including the aforementioned materials.

The second interlayer insulating layer 107 may be disposed on the capacitor Cst. For example, the second interlayer insulating layer 107 may be disposed directly on the second capacitor electrode CE2 of the capacitor Cst. In an embodiment, the second interlayer insulating layer 107 may include an inorganic insulator such as silicon oxide, silicon nitride, silicon oxynitride, or the like, and may include a single-layered or multi-layered structure including the inorganic insulator.

A semiconductor layer A3 (hereinafter, referred to as a third semiconductor layer) of the third thin-film transistor T3 may be disposed on the second interlayer insulating layer 107 (e.g., disposed directly thereon in the z direction). In an embodiment, the third semiconductor layer A3 may include an oxide-based semiconductor material. For example, the third semiconductor layer A3 may include a Zn oxide-based material, such as Zn oxide, In-Zn oxide, Ga-In-Zn oxide, and the like. In some embodiments, the third semiconductor layer A3 may include an In-Ga-Zn-O (IGZO) semiconductor, an In-Sn-Zn-O (ITZO) semiconductor, or an In-Ga-Sn-Zn-O (IGTZO) semiconductor, which includes a metal such as indium (In), gallium (Ga), or tin (Sn) in addition to ZnO.

The third semiconductor layer A3 may include a channel area and impurity areas arranged at two sides of the channel area. Any one of the impurity areas may correspond to a source area, and the other one may correspond to a drain area.

The third thin-film transistor T3 may include a gate electrode GE3 (hereinafter, referred to as a third gate electrode) overlapping the channel area of the third semiconductor layer A3 (e.g., in the z direction). In an embodiment, the third gate electrode GE3 may have a dual-gate structure including a lower gate electrode G3A disposed under the third semiconductor layer A3 (e.g., in the z direction) and an upper gate electrode G3B disposed above the third semiconductor layer A3 (e.g., in the z direction).

In an embodiment, the lower gate electrode G3A and the second capacitor electrode CE2 of the capacitor Cst may be disposed on (e.g., disposed directly thereon) a same layer as each other (e.g., the first interlayer insulating layer 105). In an embodiment, the lower gate electrode G3A may include a same material as the material of the second capacitor electrode CE2 of the capacitor Cst.

The upper gate electrode G3B may be disposed above the third semiconductor layer A3 with the second gate insulating layer 109 therebetween (e.g., in the z direction). In an embodiment, the second gate insulating layer 109 may include an inorganic insulator such as silicon oxide, silicon nitride, or silicon oxynitride, and may include a single-layered or multi-layered structure including the aforementioned inorganic insulator.

The third interlayer insulating layer 110 may be disposed on (e.g., disposed directly thereon) the upper gate electrode G3B. In an embodiment, the third interlayer insulating layer 110 may include an inorganic insulator such as silicon oxynitride, and may include a single-layered or multi-layered structure including the aforementioned inorganic insulator.

Although FIG. 7 illustrates the first thin-film transistor T1 and the third thin-film transistor T3 among the plurality of thin-film transistors and the first semiconductor layer A1 and the third semiconductor layer A3 are disposed on different layers from each other, embodiments of the present disclosure are not necessarily limited thereto.

In an embodiment, the second thin-film transistor T2, the fifth thin-film transistor T5, the sixth thin-film transistor T6, the seventh thin-film transistor T7 (see FIG. 5), which have been described with reference to FIG. 5, may have a structure identical to the structure of the first thin-film transistor T1 described with reference to FIG. 7. For example, the second thin-film transistor T2, the fifth thin-film transistor T5, the sixth thin-film transistor T6, and the seventh thin-film transistor T7 (see FIG. 5) may include a semiconductor layer disposed on a same layer as the first semiconductor layer A1 of the first thin-film transistor T1 and a gate electrode disposed on a same layer as the first gate electrode GE1 of the first thin-film transistor T1.

In an embodiment, the fourth thin-film transistor T4 described with reference to FIG. 5 may have a structure identical to the structure of the third thin-film transistor T3 described with reference to FIG. 7. For example, the fourth thin-film transistor T4 may include a semiconductor layer disposed on a same layer as the third semiconductor layer A3 of the third thin-film transistor T3 and a gate electrode formed on a same layer as the third gate electrode GE3 of the third thin-film transistor T3. In an embodiment, the semiconductor layer of the fourth thin-film transistor T4 and the third semiconductor layer A3 of the third thin-film transistor T3 may be integrally connected to each other.

The first thin-film transistor T1 and the third thin-film transistor T3 may be electrically connected to each other through a first connection electrode CM. In an embodiment, the first connection electrode CM may be disposed on (e.g., disposed directly thereon) the third interlayer insulating layer 110. One side of the first connection electrode CM may directly contact the first gate electrode GE1 of the first thin-film transistor T1, and the other side of the first connection electrode CM may directly contact the third semiconductor layer A3 of the third thin-film transistor T3. For example, one side of the first connection electrode CM may pass through a contact hole penetrating the third interlayer insulating layer 110, the second gate insulating layer 109, the second interlayer insulating layer 107 and the first interlayer insulating layer 105 to directly contact the first gate electrode GE1. The other side of the first connection electrode CM may pass through a contact hole penetrating the third interlayer insulating layer 110 and the second gate insulating layer 109 to directly contact the third semiconductor layer A3.

In an embodiment, the first connection electrode CM may include Al, Cu, and/or Ti, and may include a single layer or multiple layers including the aforementioned materials. For example, the first connection electrode CM may have a three-layer structure including Ti/AI/Ti.

A first planarization layer 111 may be disposed on (e.g., disposed directly thereon) the first connection electrode CM.

The data line DL and a second connection electrode CM' may be disposed on (e.g., disposed directly thereon in the z direction) the first planarization layer 111 and covered with a second planarization layer 113. The second connection electrode CM' may be electrically connected to the first connection electrode CM through a contact hole penetrating the first planarization layer 111.

In an embodiment, each of the data line DL and the second connection electrode CM' may include Al, Cu, and/or Ti, and may include a single layer or multiple layers including the aforementioned materials. For example, each of the data line DL and the second connection electrode CM' may have a three-layer structure including Ti/AI/Ti.

Although FIG. 7 illustrates that the data line DL is disposed on (e.g., disposed directly thereon in the z direction) the first planarization layer 111 and is positioned on a same layer as the second connection electrode CM', embodiments of the present disclosure are not necessarily limited thereto. For example, in an embodiment, the data line DL and the first connection electrode CM may be disposed on a same layer as each other.

A light-emitting diode, such as the organic light-emitting diode OLED, may be disposed on the second planarization layer 113 (e.g., disposed directly thereon in the z direction). The organic light-emitting diode OLED may be electrically connected to the second connection electrode CM' through a contact hole extending through the second planarization layer 113. The organic light-emitting diode OLED may be electrically connected to the subpixel circuit PC through the first connection electrode CM and the second connection electrode CM'.

In an embodiment, a subpixel electrode 210 of the organic light-emitting diode OLED may include a reflective film including silver (Ag), magnesium (Mg), Al, platinum (Pt), palladium (Pd), gold (Au), nickel (Ni), neodymium (Nd), iridium (Ir), chromium (Cr), or compounds thereof. However, embodiments of the present disclosure are not necessarily limited thereto. For example, in an embodiment, the subpixel electrode 210 may further include a conductive oxide layer above and/or under (e.g., in the z direction) the aforementioned reflective film. In an embodiment, the conductive oxide layer may include indium tin oxide (ITO), indium zinc oxide (IZO), zinc oxide (ZnO), indium oxide (In₂O₃), indium gallium oxide (IGO), and/or aluminum zinc oxide (AZO). In an embodiment, the subpixel electrode 210 may include a three-layer structure including an ITO layer/an Ag layer/an ITO layer.

A bank layer 115 may be disposed on (e.g., disposed directly thereon) the subpixel electrode 210. The bank layer 115 may include an opening overlapping the subpixel electrode 210 and covering an edge of the subpixel electrode 210. In an embodiment, the bank layer 115 may include an organic insulator.

An intermediate layer 220 includes an emission layer 222. The intermediate layer 220 may include a function layer 220f. The function layer 220f may include a first function layer 221 disposed under the emission layer 222 and/or a second function layer 223 disposed above the emission layer 222. In an embodiment, the emission layer 222 may include a high-molecular weight or low-molecular weight organic material emitting light having certain colors. The second function layer 223 may include an electron transport layer (ETL) and/or an electron injection layer (EIL). The first function layer 221 and the second function layer 223 may include organic materials.

A counter electrode 230 may include a conductive material having a small work function. For example, in an embodiment the counter electrode 230 may include a (semi) transparent layer including Ag, Mg, Al, Pt, Pd, Au, Ni, Nd, Ir, Cr, Li, Ca, or alloys thereof. Alternatively, the counter electrode 230 may further include a layer including ITO, IZO, ZnO, In₂O₃, or the like on the (semi) transparent layer including the aforementioned materials.

The emission layer 222 may be formed on the display area DA to overlap the subpixel electrode 210 (e.g., in the z direction) through the opening in the bank layer 115. In contrast, in an embodiment the first function layer 221, the second function layer 223, and the counter electrode 230 may extend to be in the middle area MA, as well as the display area DA.

The organic light-emitting diode OLED may be covered with an encapsulation layer 300. In an embodiment, the encapsulation layer 300 may include at least one organic encapsulation layer and at least one inorganic encapsulation layer. In an embodiment shown in FIG. 7, the encapsulation layer 300 includes a first inorganic encapsulation layer 310, a second inorganic encapsulation layer 330, and an organic encapsulation layer 320 disposed therebetween (e.g., in the z direction). However, embodiments of the present disclosure are not necessarily limited thereto and the encapsulation layer 300 may include at least one organic encapsulation layer and at least one inorganic encapsulation layer having various different arrangements.

In an embodiment, the first inorganic encapsulation layer 310 and the second inorganic encapsulation layer 330 may each include one or more inorganic materials among aluminum oxide, titanium oxide, tantalum oxide, hafnium oxide, zinc oxide, silicon oxide, silicon nitride, and silicon oxynitride. The first inorganic encapsulation layer 310 and the second inorganic encapsulation layer 330 may each include a single layer or multiple layers including the aforementioned materials. In an embodiment, the organic encapsulation layer 320 may include a polymer-based material. The polymer-based material may include an acryl-based resin, an epoxy-based resin, polyimide, polyethylene, and the like. In an embodiment, the organic encapsulation layer 320 may include acrylate.

The first inorganic encapsulation layer 310 and the second inorganic encapsulation layer 330 may have different thicknesses (e.g., length in the z direction) from each other. In an embodiment, a thickness of the first inorganic encapsulation layer 310 may be greater than a thickness of the second inorganic encapsulation layer 330. Alternatively, the thickness of the second inorganic encapsulation layer 330 may be greater than the thickness of the first inorganic encapsulation layer 310, or the first inorganic encapsulation layer 310 and the second inorganic encapsulation layer 330 may have a same thickness as each other.

Referring to the middle area MA shown in FIG. 7, partition walls PW and separators SP may be arranged to be spaced apart from each other between the display area DA and the opening area OA. In an embodiment, the encapsulation layer 300 may extend to the middle area MA and cover the partition walls PW and the separators SP.

In an embodiment, the partition walls PW may include a first partition wall PW1 and a second partition wall PW2. The first partition wall PW1 may be arranged between the display area DA and the opening area OA, and the second partition wall PW2 may be arranged between the first partition wall PW1 and the opening area OA. In a plan view, the first partition wall PW1 and the second partition wall PW2 may be arranged along a periphery of the opening area OA. Although FIG. 7 illustrates that two partition walls PW are arranged in the middle area MA, embodiments of the present disclosure are not necessarily limited thereto. In some embodiments, one, three, or four or more partition walls PW may be disposed in the middle area MA.

In an embodiment, the first partition wall PW1 and the second partition wall PW2 may be disposed on a top surface of the inorganic insulating layer IIL. For example, the first partition wall PW1 and the second partition wall PW2 may be disposed on a top surface of the third interlayer insulating layer 110 (e.g., disposed directly thereon in a z direction).

In an embodiment, the first partition wall PW1 may include a portion 111P1 of the first planarization layer 111, a portion 113P1 of the second planarization layer 113, and a portion 115P1 of the bank layer 115. The second partition wall PW2 may include a portion 111P2 of the first planarization layer 111, a portion 113P2 of the second planarization layer 113, and a portion 115P2 of the bank layer 115. However, embodiments of the present disclosure are not necessarily limited thereto and in some embodiments, the first partition wall PW1 and the second partition wall PW2 may further include portions of other layers, or some of the aforementioned layers may be omitted.

The separators SP may be disposed on a top surface of the inorganic insulating layer IIL. For example, the separators SP may be arranged to be spaced apart from one another, on the top surface of the third interlayer insulating layer 110, in a direction parallel to a top surface of the substrate 100. In an embodiment, the separators SP adjacent to one another may be arranged at certain intervals IV. The interval IV between the separators SP adjacent to one another may indicate an area in which an organic pattern layer 1110 included in each separator SP is not arranged.

An embodiment shown in FIG. 7 includes five separators SP arranged in the middle area MA. For example, two separators SP may be arranged between the display area DA and the first partition wall PW1, two separators SP may be arranged between the first partition wall PW1 and the second partition wall PW2, and one separator SP may be arranged between the second partition wall PW2 and the opening area OA. However, embodiments of the present disclosure are not limited thereto. For example, in some embodiments, one to four, or six or more separators SP may be arranged in the middle area MA.

Referring to FIGS. 7 and 8, the separator SP may have a stack structure including the organic pattern layer 1110 and at least one metal layer. For example, in an embodiment, the separator SP may have a stack structure including the organic pattern layer 1110 and a metal pattern layer ML. The metal pattern layer ML may be arranged to overlap the organic pattern layer 1110. For example, the metal pattern layer ML may cover the organic pattern layer 1110. The separator SP may include a groove G. The separator SP may include at least one tip TP. For example, in an embodiment, the separator SP may include two tips TP at two sides (e.g., lateral sides) of the groove G (e.g., in a cross-sectional view). The tip TP may overlap the groove G (e.g., in the z direction).

The organic pattern layer 1110 may be disposed on the inorganic insulating layer IIL. For example, the organic pattern layer 1110 may be disposed on the third interlayer insulating layer 110 (e.g., disposed directly thereon in the z direction). In an embodiment, the organic pattern layer 1110 may be disposed on a same layer as the first planarization layer 111 and may include a same material as a material of the first planarization layer 111. In an embodiment, the organic pattern layer 1110 and the first planarization layer 111 may be formed in a same process.

The groove G may be provided in the organic pattern layer 1110. The groove G may have a shape defined by the removal of a portion of the organic pattern layer 1110 in a thickness direction. Although FIGS. 7 and 8 illustrate that the groove G is defined by an internal surface 1110is organic pattern layer 1110, embodiments of the present disclosure are not necessarily limited thereto. For example, in some embodiments a lower metal layer overlapping the organic pattern layer 1110 may be disposed between the organic pattern layer 1110 and the inorganic insulating layer IlL (e.g. in the z direction). The groove G may expose at least a portion of a top surface of the lower metal layer. The groove G may be defined by the internal surface 1110is of the organic pattern layer 1110 and the top surface of the lower metal layer.

The organic pattern layer 1110 may include a first portion 1110a overlapping the groove G (e.g., in the z direction) and second portions 1110b extending outside of the first portion 1110a. In an embodiment, the second portions 1110b of the organic pattern layer 1110 may not overlap the groove (e.g., in the z direction). The second portions 1110b may include edge portions (e.g., lateral edge portions) of the organic pattern layer 1110. In an embodiment, a top surface 1110t, which corresponds to the second portions 1110b of the organic pattern layer 1110, may include a slope. In an embodiment, the slope of the top surface 1110t of the organic pattern layer 1110 has a declined slope extending in a direction towards a top surface 100t of the substrate 100. Although FIGS. 7 and 8 illustrate that the top surface 1110t corresponding to the second portions 1110b of the organic pattern layer 1110 has the slopes having certain angles, embodiments of the present disclosure are not necessarily limited thereto. For example, in some embodiments, the top surface 1110t corresponding to the second portions 1110b of the organic pattern layer 1110 may include slopes respectively having different angles. In an embodiment, the angles of the slopes may decrease from the edges of the organic pattern layer 1110 towards a center of the organic pattern layer 1110. For example, the top surface 1110t corresponding to the second portions 1110b of the organic pattern layer 1110 may have a shape recessed in the direction towards the top surface 100t of the substrate 100. In the present specification, an angle of the slope indicates an angle between the slope and the top surface 100t of the substrate 100. In an embodiment, in a cross-section, the top surface 1110t of the organic pattern layer 1110 may include a first point P1 having a greatest vertical distance from the top surface 110t of the substrate 100 (e.g., in the z direction) as compared to all other surfaces of the organic pattern layer 1110. For example, the top surface 1110t of the second portion 1110b of the organic pattern layer 1110 may include the first point P1 which is the portion of the organic pattern layer 1110 having the greatest vertical distance from the top surface 100t of the substrate 100.

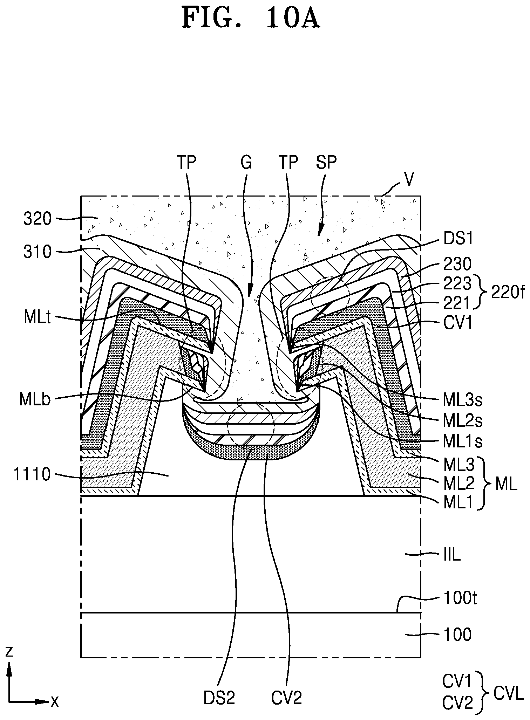

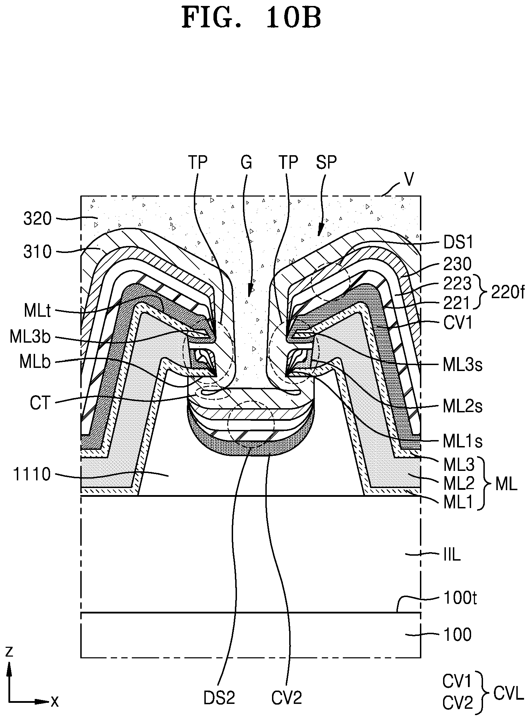

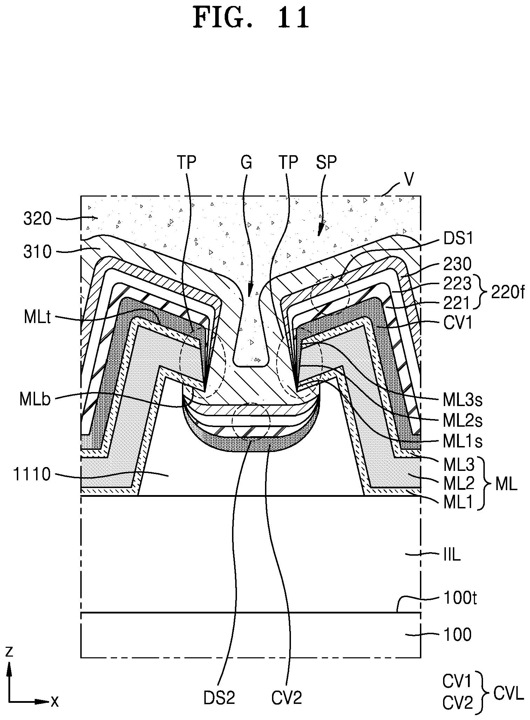

In an embodiment, the metal pattern layer ML may include a same material as the material of the data line DL and/or the second connection electrode CM'. In an embodiment, the metal pattern layer ML and the data line DL and/or the second connection electrode CM' may be formed in a same process. In an embodiment, as illustrated in FIGS. 10A, 10B, and 11 to be described later, the metal pattern layer ML may have a multi-layered structure including a first sub layer ML1, a second sub layer ML2, and a third sub layer ML3. In an embodiment, the first sub layer ML1 and the third sub layer ML3 may include a same material as each other, and the first sub layer ML1 and the second sub layer ML2 may respectively include different materials from each other. For example, in an embodiment the first sub layer ML1 and the third sub layer ML3 may include Ti, and the second sub layer ML2 may include Al.

The metal pattern layer ML may be disposed on the top surface 1110t of the organic pattern layer 1110 (e.g., disposed directly thereon). The metal pattern layer ML may at least partially cover the top surface 1110t and an external surface 1110es (e.g., an outer surface) of the organic pattern layer 1110. The metal pattern layer ML may extend to an area in which the organic pattern layer 1110 is not arranged. In an embodiment, the metal pattern layer ML may directly contact a top surface of the inorganic insulating layer IIL disposed at a level below the organic pattern layer 1110 in the area in which the organic pattern layer 1110 is not arranged, such as the interval IV between adjacent separators SP. The metal pattern layer ML and the inorganic insulating layer IlL (e.g., the third interlayer insulating layer 110) in direct contact with each other may form an inorganic contact region ICR. In an embodiment, the interval IV between the separators SP adjacent to each other may include an inorganic contact region ICR. By including the inorganic contact region ICR, the middle area MA may prevent moisture and the like from proceeding towards the display area DA through the organic pattern layer 1110.

The metal pattern layer ML may include the tip TP. In an embodiment, the tip TP of the metal pattern layer ML may include a portion extending towards a center of the groove G. The tip TP may include a portion extending from a second point P2, at which the internal surface 1110is of the organic pattern layer 1110 meets a bottom surface MLb of the metal pattern layer ML, towards the center of the groove G. The tip TP may include a portion that is a part of the metal pattern layer ML and does not directly contact the organic pattern layer 1110.

Referring to FIGS. 7 and 8, a virtual line (e.g., an imaginary line) passing the first point P1 of the organic pattern layer 1110 and an edge TPe of the tip TP of the metal pattern layer ML may have a declined slope extending in a direction towards the top surface of the substrate 100 (e.g., a - z direction). In an embodiment, an angle formed by the virtual line passing the first point P1 of the organic pattern layer 1110 and the edge TPe of the tip TP of the metal pattern layer ML and the top surface 100t of the substrate 100 may be greater than 0° but less than 90°. A vertical height of the first point P1 may be greater than a vertical height of the edge TPe of the tip TP of the metal pattern layer ML. With respect to the virtual line, the edge TPe of the tip TP may refer to the point of the tip TP that is closest to the center of the groove G.

In an embodiment, the tip TP of the metal pattern layer ML may not extend parallel to the top surface 100t of the substrate 100. For example, an entirety of a lower surface of the tip TP of the metal pattern layer ML may have a declined slope extending in the direction (e.g., the - z direction) towards the top surface 100t of the substrate 100. The tip TP of the metal pattern layer ML may have a declined slope extending in the direction (e.g., the - z direction) towards the top surface 100t of the substrate 100 along the slope of the top surface 1110t of the organic pattern layer 1110 on which the metal pattern layer ML is disposed.

The first dummy stack DS1 including layers disposed on the metal pattern layer ML, such as a first cover portion CV1 of the cover layer CVL to be described later, the function layer 220f, and the counter electrode 230, may have a slope structure identical to a slope structure of the metal pattern layer ML.

As a comparative example, when the virtual line passing the first point of the organic pattern layer and the edge of the tip of the metal pattern layer has an inclined slope extending in a direction (e.g., a z direction) away from the top surface of the substrate or is parallel to the top surface of the substrate, organic material layers formed on the tip, such as the function layer, may be deposited onto the bottom surface of the tip (e.g., the bottom surface of the metal pattern layer), and may be not cut off or separated by the tip. In this comparative embodiment, moisture and the like introduced into the opening of the display apparatus may move towards the display area DA through the function layer.

However, according to an embodiment, the virtual line passing the first point P1 of the organic pattern layer 1110 and the edge TPe of the tip TP of the metal pattern layer ML may have a declined slope extending in the direction (e.g., the - z direction) towards the top surface of the substrate 100. Accordingly, the function layer 220f formed on the tip TP may be not deposited onto the bottom surface of the tip TP (e.g., the bottom surface MLb of the metal pattern layer ML), and may be cut off and separated by the tip TP. Accordingly, the forming of a moisture-permeation path through the function layer 220f may be prevented. Thus, the reliability of the display apparatus 10 may be increased.

In an embodiment, the separator SP may have a stack structure including the organic pattern layer 1110, the metal pattern layer ML, and a cover layer CVL. In an embodiment, a portion of the cover layer CVL may be cut off at a side surface MLs of the metal pattern layer ML. The cover layer CVL may include the first cover portion CV1 covering (e.g., and disposed directly thereon) the top surface MLt and the side surface MLs of the metal pattern layer ML and a second cover portion CV2 arranged in the groove G. The first cover portion CV1 and the second cover portion CV2 may be spaced apart from each other and may not directly contact each other (e.g., be isolated from each other).

The second cover portion CV2 may directly contact at least a portion of the internal surface 1110is of the organic pattern layer 1110 defining the groove G. The second cover portion CV2 may expose at least a portion of the organic pattern layer 1110. In an embodiment, the second cover portion CV2 may expose an area adjacent to the metal pattern layer ML in the internal surface 1110is of the organic pattern layer 1110 defining the groove G.

Likewise, the function layer 220f and the counter electrode 230 to be described later may have a shape partially cut off from the side surface of the metal pattern layer ML. In this embodiment, introduction of impurities such as moisture toward the display area DA may be more efficiently prevented through the function layer 220f.

In an embodiment, the cover layer CVL may include a metal material. The cover layer CVL may include, for example, materials identical to the materials of the subpixel electrode 210. In an embodiment, the cover layer CVL and the subpixel electrode 210 may be formed in a same process. In an embodiment, the cover layer CVL may have a three-layer structure including ITO/Ag/ITO.

In the intermediate layer 220 of the display area DA, the function layer 220f and the counter electrode 230 may extend to the middle area MA. The function layer 220f may include an organic material and thus may be a proceeding path for moisture. When external moisture is introduced through the opening 10OP of the display apparatus 10 and reaches the organic light-emitting diode OLED, the organic light-emitting diode OLED may be damaged. However, as shown in FIGS. 7 and 8, in the middle area MA, the function layer 220f and the counter electrode 230 may be discontinuously arranged due to the separators SP.

When depositing the function layer 220f, such as the first function layer 221 and/or the second function layer 223, materials included in the first function layer 221 and/or the second function layer 223 may be discontinuously deposited by the groove G of the separator SP. As shown in FIGS. 7 and 8, the function layer 220f may include a first portion disposed on the top surface of the separator SP and a second portion in the groove G of the separator SP, and the first portion and the second portion may be isolated and separated from each other. Accordingly, the separator SP may prevent moisture and the like introduced through the opening 10OP from proceeding towards the display area DA through the function layer 220f including organic materials.

Like the function layer 220f, the counter electrode 230 of the organic light-emitting diode OLED may also include portions discontinuously arranged in the middle area MA. For example, a first portion of the counter electrode 230, which is disposed on the top surface of the separator SP, and the second portion of the counter electrode 230, which is in the groove G, may be cut off and separated from each other.

For example, a stack (hereinafter, referred to as a first dummy stack DS1) including the function layer 220f and the counter electrode 230 disposed on the top surface of the separator SP may be separated from a stack (hereinafter, referred to as a second dummy stack DS2) including the function layer 220f and the counter electrode 230 in the groove G. In an embodiment, the first dummy stack DS1 may be disposed on (e.g., disposed directly thereon) the first cover portion CV1 of the cover layer CVL. The second dummy stack DS2 may be disposed on (e.g., disposed directly thereon) the second cover portion CV2 of the cover layer CVL.

The function layer 220f and the counter electrode 230 separated by the separator SP may be covered with an inorganic encapsulation layer. For example, as shown in FIG. 7, the first inorganic encapsulation layer 310 may cover the function layer 220f and the counter electrode 230 separated by the groove G of the separator SP. The first inorganic encapsulation layer 310 has relatively excellent step coverage, and thus may be continuous in the middle area MA.

The organic encapsulation layer 320 may cover at least a portion of the middle area MA. The organic encapsulation layer 320 may cover some of the separators SP. In an embodiment, the organic encapsulation layer 320 may cover, for example, the separators SP arranged between the display area DA and the separators SP between the first partition wall PW1 and the second partition wall PW2. The second inorganic encapsulation layer 330 may generally cover the middle area MA on the organic encapsulation layer 320.

When the organic encapsulation layer 320 is formed, a flow of monomers may be controlled by the partition walls PW and/or the separators SP. In an embodiment, the organic encapsulation layer 320 in the middle area MA may be discontinuous due to the partition walls PW. For example, one portion of the organic encapsulation layer 320 may cover an area from the display area DA to the first partition wall PW1, and another portion of the organic encapsulation layer 320 may cover an area between the first partition wall PW1 and the second partition wall PW2. On the first partition wall PW1 that is a point at which the organic encapsulation layer 320 ends, a portion of the second inorganic encapsulation layer 330 may be in direct contact with a portion of the first inorganic encapsulation layer 310.

Referring to the opening area OA, the display apparatus 10 may include the opening 10OP. In an embodiment, the opening 10OP of the display apparatus 10 may include openings of elements included in the display apparatus 10. For example, the opening 10OP of the display apparatus 10 may include an opening 100OP of the substrate 100, an opening 310OP of the first inorganic encapsulation layer 310, an opening 330OP of the second inorganic encapsulation layer 330, and the like.

In an embodiment, the openings of the elements included in the display apparatus 10 may be simultaneously formed. Accordingly, an internal surface 100IS of the substrate 100 defining the opening 100OP of the substrate 100 and internal surfaces 310IS and 330IS of the first inorganic encapsulation layer 310 and the second inorganic encapsulation layer 330 respectively defining the opening 310OP of the first inorganic encapsulation layer and the opening 330OP of the second inorganic encapsulation layer 330 may be on a same vertical line as each other.

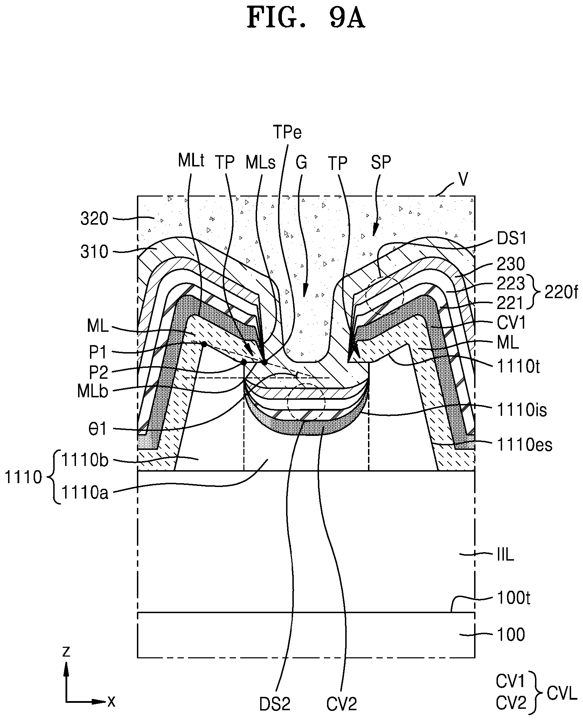

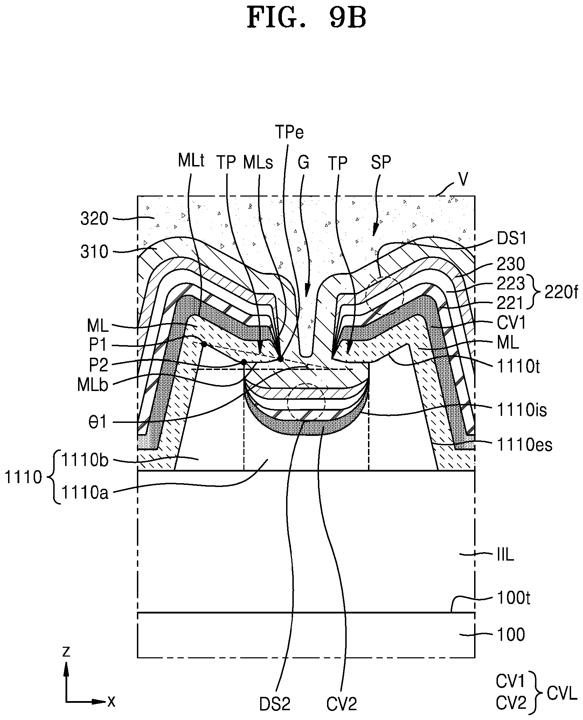

FIGS. 9A and 9B are cross-sectional views of portions of the display apparatus 10 according to embodiments of the present disclosure. FIGS. 9A and 9B illustrate embodiments modified from the embodiment shown in FIG. 8, and embodiments in FIGS. 9A and 9B are different from an embodiment in FIG. 8 in terms of a structure of the tip TP of the metal pattern layer ML. Hereinafter, differences will be mainly described, and a repeated descriptions of identical or similar elements may be omitted for economy of description.

In a cross-section, the top surface 1110t of the organic pattern layer 1110 may include the first point P1 having the greatest vertical distance from the top surface 100t of the substrate 100. The virtual line passing the first point P1 of the organic pattern layer 1110 and the edge TPe of the tip TP of the metal pattern layer ML may have a declined slope extending in the direction (e.g., the - z direction) towards the top surface of the substrate 100. In an embodiment, an angle formed by the virtual line passing the first point P1 of the organic pattern layer 1110 and the edge TPe of the tip TP of the metal pattern layer ML and the top surface 100t of the substrate 100 may be greater than 0° and less than 90°.

Referring to FIG. 9A, at least a portion of the tip TP of the metal pattern layer ML may extend parallel to the top surface 100t of the substrate 100 and may not have the declined slope. In an embodiment, as illustrated in FIG. 9A, an entirety of the tip TP of the metal pattern layer ML may extend generally parallel to the top surface 100t of the substrate 100. However, embodiments of the present disclosure are not necessarily limited thereto. For example, in an embodiment, only a portion of the tip TP of the metal pattern layer ML may have a declined slope extending in the direction (e.g., the -z direction) towards the top surface 100t of the substrate 100. For example, in the tip TP of the metal pattern layer ML, a portion adjacent to the second point P2 may have a declined slope extending in the direction (e.g., the - z direction) towards the top surface 100t of the substrate 100 and the remaining portion of the tip TP may extend parallel to the top surface 100t of the substrate 100. In an embodiment, the tip TP of the metal pattern layer ML may have a slope having an angle that decreases from the portion adjacent to the second point P2 towards the edge TPe. The edge TPe of the tip TP of the metal pattern layer ML may extend parallel to the top surface 100t of the substrate 100. In the present specification, the angle of the slope of the tip TP indicates an angle formed by the tip TP and the top surface 100t of the substrate 100.

Referring to FIG. 9B, at least a portion of the tip TP of the metal pattern layer ML may have an inclined slope extending in the direction (e.g., the z direction) away from the top surface 100t of the substrate 100. In an embodiment, as illustrated in FIG. 9B, the edge TPe of the tip TP of the metal pattern layer ML may have an inclined slope in the direction (e.g., the z direction) away from the top surface 100t of the substrate 100. In an embodiment, at least a portion of the tip TP of the metal pattern layer ML may extend parallel to the top surface 100t of the substrate 100. For example, in the tip TP of the metal pattern layer ML, the portion adjacent to the second point P2 may extend parallel to the top surface 100t of the substrate 100. The angle of the slope of the tip TP of the metal pattern layer ML may increase from the portion adjacent to the second point P2 towards the edge TP3. However, embodiments of the present disclosure are not necessarily limited thereto. For example, in an embodiment, the tip TP of the metal pattern layer ML may have a declined slope extending in the direction (e.g., the - z direction) towards the top surface 100t of the substrate 100 and the portion adjacent to the second point P2 may have an inclined slope extending in the direction (e.g., the z direction) away from the top surface 100t of the substrate 100.

FIGS. 10A, 10B, and 11 are cross-sectional views each illustrating a portion of the display apparatus 10 according to embodiments of the present disclosure. FIGS. 10A, 10B, and 11 illustrate embodiments modified from embodiments shown in FIGS. 8, 9A, and 9B. Hereinafter, differences will be mainly described, and a repeated description of similar or identical elements may be omitted for economy of description

The metal pattern layer ML may include the tip TP. A structure of the tip TP of the metal pattern layer ML described with reference to FIGS. 8 to 9B may be applied to FIGS. 10A to 11. For example, in an embodiment the tip TP of the metal pattern layer ML illustrated in FIGS. 10A and 11 may have a slope structure identical to a slope of the tip TP of the metal pattern layer ML illustrated in FIG. 8. The tip TP of the metal pattern layer ML illustrated in FIG. 10B may extend parallel to the top surface 100t of the substrate 100 identical to the structure of the tip TP of the metal pattern layer ML illustrated in FIG. 9A.

Referring to FIG. 10A to 11, the metal pattern layer ML may be provided as a plurality of sublayers. For example, in an embodiment the metal pattern layer ML may have a multi-layer structure including the first sub layer ML1, the second sub layer ML2, and the third sub layer ML3 (e.g., consecutively stacked). With respect to the virtual line passing the first point P1 of the organic pattern layer 1110 and the edge TPe of the tip TP of the metal pattern layer ML, the edge TPe of the tip TP may refer to the point of the first sub layer ML1 of the tip TP that is closest to the center of the groove G.

The cover layer CVL may be disposed on (e.g., disposed directly thereon) the metal pattern layer ML. The cover layer CVL may include the first cover portion CV1 and the second cover portion CV2 spaced apart from each other and isolated from each other. In an embodiment in which the metal pattern layer ML is provided as the plurality of sub layers, the first cover portion CV1 may cover a side surface of each of the plurality of sublayers. Referring to FIGS. 10A, 10B, and 11, the metal pattern layer ML includes the first sub layer ML1 to the third sub layer ML3, and therefore, the side surface MLs of the metal pattern layer ML may indicate a side surface ML1s of the first sub layer ML1, a side surface ML2s of the second sub layer ML2, and a side surface ML3s of the third sub layer ML3. The first cover portion CV1 may extend from the top surface MLt of the metal pattern layer ML to the side surface ML3s of the third sub layer ML3, the side surface ML2s of the second sub layer ML2, and the side surface ML1s of the first sub layer ML1. Referring to FIGS. 10A and 10B, in an embodiment, the first sub layer ML1 and the third sub layer ML3 may extend further than the second sub layer ML2 towards the center of the groove G. For example, the third sub layer ML3 may extend towards the center of the groove G from a point at which the side surface ML2s of the second sub layer ML2 meets a bottom surface of the third sub layer ML3. However, embodiments of the present disclosure are not necessarily limited thereto. For example, as illustrated in FIG. 11, in an embodiment, the first sub layer ML1 and the third sub layer ML3 may not extend further than the second sub layer ML2 toward the center of the groove G. For example, the first sub layer ML1 and the third sub layer ML3 may not protrude with reference to the second sub layer ML2. In this embodiment, the side surface ML1s of the first sub layer ML1 and the side surface ML3s of the third sub layer ML3 may be on a substantially same line as a side surface of the side surface ML2s of the second sub layer ML2.

In an embodiment, the first cover portion CV1 may be partially cut off on the side surface MLs of the metal pattern layer ML. In an embodiment, as illustrated in FIG. 10A, as the third sub layer ML3 extends further than the second sub layer ML2 towards the center of the groove G, the first cover portion CV1 may be not deposited on the bottom surface of the third sub layer ML3. However, embodiments of the present disclosure are not necessarily limited thereto. For example, in some embodiments, as illustrated in FIG. 10B, the first cover portion CV1 may be deposited on (e.g., disposed directly thereon) the bottom surface of the third sub layer ML3. In this embodiment, the first cover portion CV1 may be not deposited on (e.g., disposed directly thereon) a portion of the side surface ML2s of the second sub layer ML2.

The function layer 220f and the counter electrode 230 may be sequentially disposed on the cover layer CVL. In addition, the first inorganic encapsulation layer 310 and the second inorganic encapsulation layer 330 may be sequentially disposed on the counter electrode 230. In some embodiments, as illustrated in FIG. 10B, a cavity CT, in which the first inorganic encapsulation layer 310 and the second inorganic encapsulation layer 330 are not arranged, may be formed on a lower portion of the tip TP of the metal pattern layer ML.

However, according to an embodiment, the virtual line passing the first point P1 of the organic pattern layer 1110 and the edge TPe of the tip TP of the metal pattern layer ML may have a declined slope extending in the direction (e.g., the - z direction) towards the top surface 100t of the substrate 100. Therefore, the function layer 220f formed on the tip TP may be completely cut off and separated by the tip TP without being deposited on the bottom surface of the tip TP (e.g., the bottom surface MLb of the metal pattern layer ML). Accordingly, even when the cavity CT is formed in the lower portion of the tip TP, the danger of permeation of moisture, such as water, may be reduced.

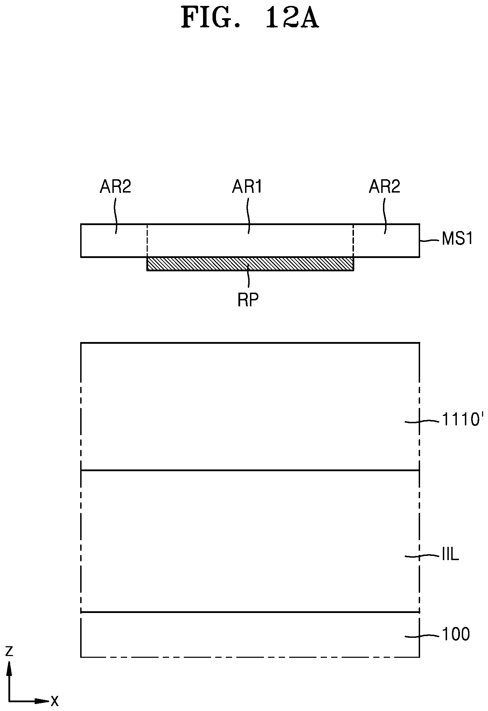

FIGS. 12A to 12G are cross-sectional views briefly illustrating a method of manufacturing the separator SP included in the display apparatus 10 according to embodiments of the present disclosure. The separators SP illustrated in FIGS. 7 and 8 may be formed through processes illustrated in FIGS. 12A to 12G.

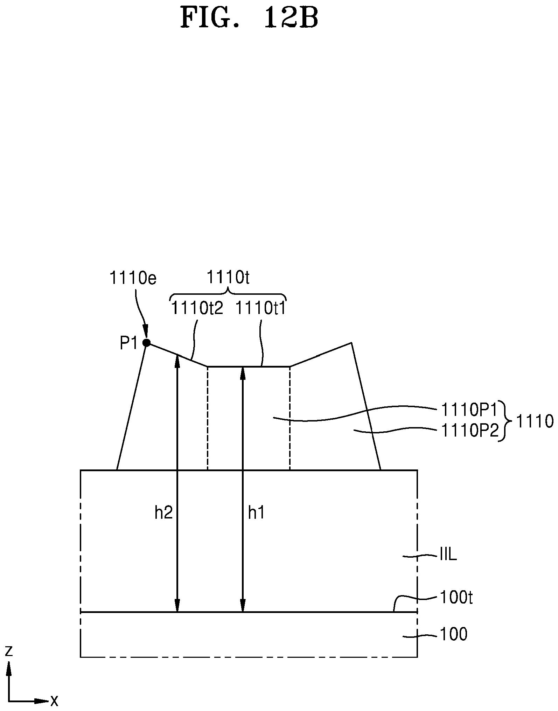

Referring to FIGS. 12A and 12B, the inorganic insulating layer IIL may be formed on (e.g., formed directly thereon) the substrate 100. A preliminary-organic pattern layer 1110' may be formed on (e.g., formed directly thereon) the inorganic insulating layer IIL.

In an embodiment, the preliminary-organic pattern layer 1110' may include a same material as the material of the first planarization layer 111 on the display area DA. In an embodiment, the preliminary-organic pattern layer 1110' may include, for example, a positive type photoresist. Although an example in which the preliminary-organic pattern layer 1110' includes the positive type photoresist is described with reference to FIGS. 12A and 12B, the preliminary-organic pattern layer 1110' may also include a negative type photoresist in some embodiments.

A first mask MS1 may be placed on (e.g., disposed directly thereon) the preliminary-organic pattern layer 1110'. In an embodiment, the first mask MS1 may include a phase shift mask (PSM). The first mask MS1 may include a first portion AR1 and a second portion AR2. A phase shift pattern RP may be disposed under the first portion AR1 and may not be disposed under the second portion AR2. The phase shift pattern RP may be configured to shift a wavelength of transmitted light. Accordingly, the phase shift pattern RP of the first mask MS1 may be configured to shift a wavelength of light transmitted through the first portion AR1.

In an embodiment, the first mask MS1 may include a rim-type phase shift mask (Rim PSM). The phase shift pattern RP may include a rim-type pattern.

The preliminary-organic pattern layer 1110' may be exposed through the first mask MS1 in different exposure amounts according to portions. The first portion AR1 and the second portion AR2 of the first mask MS1 may include transmitters. Transmittance at a portion at which the first portion AR1 of the first mask MS1 and the phase shift pattern RP overlap each other may be less than transmittance of the second portion AR2.

In an embodiment, the preliminary-organic pattern layer 1110' may then be patterned through a developing process to form the organic pattern layer 1110. The organic pattern layer 1110 and the first planarization layer 111 on the display area DA may be simultaneously formed in a same process.

The organic pattern layer 1110 may correspond to a portion exposed by the portion at which the first portion AR1 and the phase shift pattern RP overlap each other. A portion of the preliminary-organic pattern layer 1110' exposed by the second portion AR2 of the first mask MS1 may be removed in the developing process.

According to characteristics of the phase shift pattern RP, the organic pattern layer 1110 formed by the first mask MS1 may include a center portion 1110P1 and an edge portion 1110P2, as shown in FIG. 12B. An average thickness (e.g., length in the z direction) of the center portion 1110P1 of the organic pattern layer 1110 may be less than an average thickness (e.g., length in the z direction) of the edge portion 1110P2 of the organic pattern layer 1110. For example, a vertical distance h1 (e.g., length in the z direction) from the top surface 100t of the substrate 100 to a top surface 1110t1 of the center portion 1110P1 of the organic pattern layer 1110 may be less than a vertical distance h2 (e.g., length in the z direction) from the top surface 100t of the substrate 100 to a top surface 1110t2 of the edge portion 1110P2 of the organic pattern layer 1110. In an embodiment, the vertical distance h2 from the top surface 100t of the substrate 100 to the top surface 1110t2 of the edge portion 1110P2 of the organic pattern layer 1110 may decreases as a distance to the center portion 1110P1 of the organic pattern layer 1110 decreases.

The top surface 1110t2 of the edge portion 1110P2 of the organic pattern layer 1110 may include the first point P1 having the greatest vertical distance from the top surface 100t of the substrate 100.

In a cross-section, the top surface 1110t2 of the edge portion 1110P2 of the organic pattern layer 1110 may have a declined slope extending in the direction (the - z direction) towards the top surface 100t of the substrate 100. Although FIG. 12B illustrates that the top surface 1110t2 of the edge portion 1110P2 of the organic pattern layer 1110 has a slope with a constant angle, embodiments of the present disclosure are not necessarily limited thereto. For example, in an embodiment, the top surface 1110t2 of the edge portion 1110P2 of the organic pattern layer 1110 may include slopes respectively having different angles. Angles of the slopes may decrease towards the center portion 1110P1 of the organic pattern layer 1110. For example, the top surface 1110t2 of the edge portion 1110P2 of the organic pattern layer 1110 may have a shape recessed towards the top surface 100t of the substrate 100. In an embodiment, an end portion 1110e of the edge portion 1110P2 of the organic pattern layer 1110, which corresponds to the first point P1, may have an inclined shape extending in a direction (e.g. the z direction or an upward direction) away from the top surface 100t of the substrate 100.

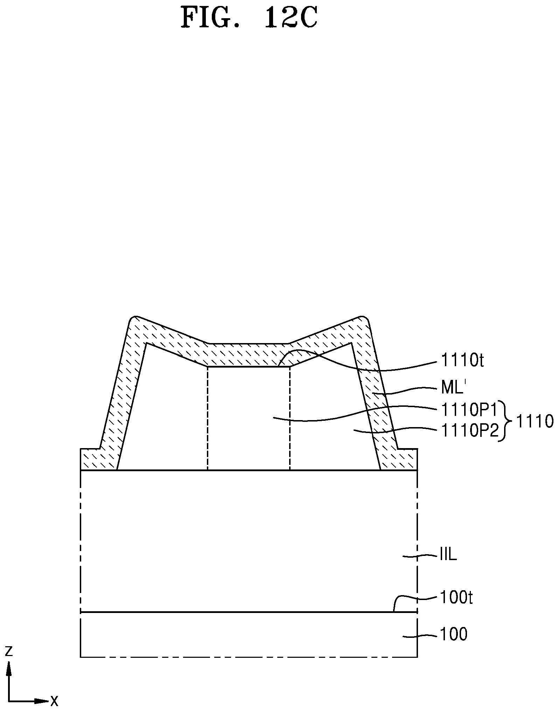

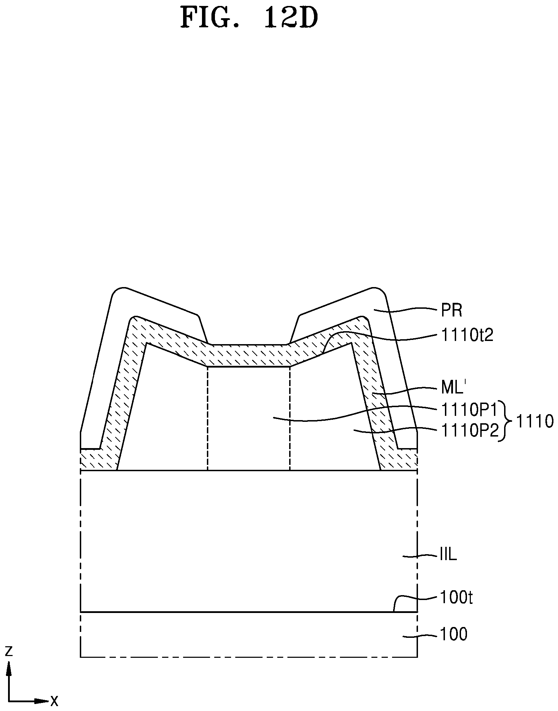

Referring to FIGS. 12C and 12D, a preliminary-metal pattern layer ML' may be formed on (e.g., formed directly thereon) the organic pattern layer 1110. The preliminary-metal pattern layer ML' may be formed directly on the top surface 1110t of the organic pattern layer 1110. A photoresist pattern PR may be formed on (e.g., formed directly thereon) the preliminary-metal pattern layer ML'. In an embodiment, the photoresist pattern PR may be formed through exposing and developing processes on the mask.

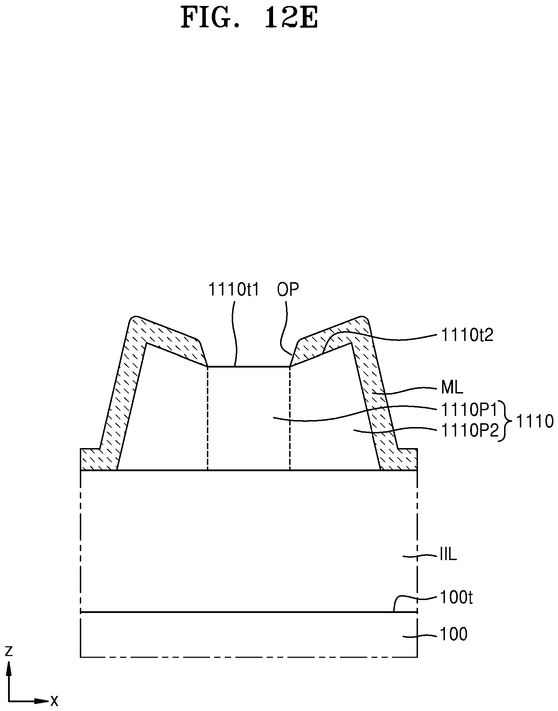

Referring to FIG. 12E, the metal pattern layer ML may be formed by patterning the preliminary-metal pattern layer ML'. In an embodiment, the metal pattern layer ML and the data line DL of the display area DA and/or the second connection electrode CM' may be simultaneously formed in a same process. An etch process to pattern the preliminary-metal pattern layer ML' may be performed through, for example, dry etch, wet etch, or a combination thereof.

The metal pattern layer ML may include an opening OP to expose at least a portion of the center portion 1110P1 of the organic pattern layer 1110. The opening OP may expose at least a portion of the top surface 1110t1 of the center portion 1110P1 of the organic pattern layer 1110.

An end portion of the metal pattern layer ML may be disposed on the top surface 1110t2 of the edge portion 1110P2 of the organic pattern layer 1110. For example, the end portion of the metal pattern layer ML may have a declined slope extending in the direction (e.g., the - z direction) towards the top surface 100t of the substrate 100.

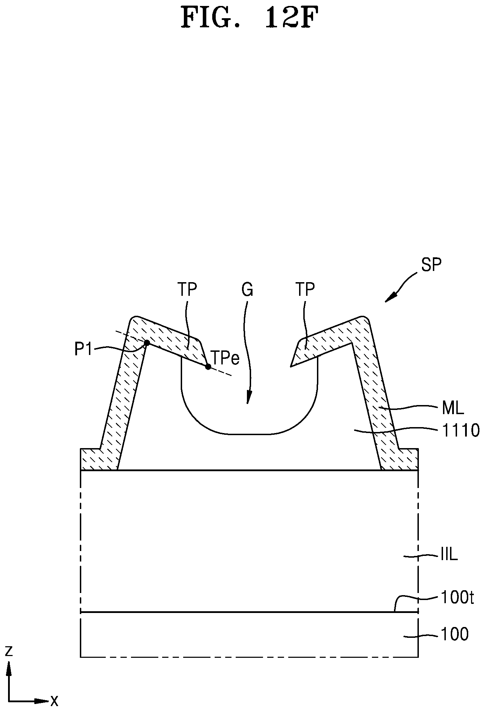

Referring to FIG. 12F, the groove G may be formed by removing a portion of the organic pattern layer 1110 using the metal pattern layer ML as a mask. In an embodiment, an etch process to remove a portion of the organic pattern layer 1110 may be performed, for example, as a dry etching process (e.g., an ashing process). For example, in the etch process, the center portion 1110P1 and the edge portion 1110P2 of the organic pattern layer 1110 may be at least partially removed. In the etch process, the tip TP provided at an end portion of the metal pattern layer ML may be formed. The virtual line passing the first point P1 of the organic pattern layer 1110 and the edge TPe of the tip TP of the metal pattern layer ML may have a declined slope extending in the direction (e.g., the - z direction) towards the top surface 100t of the substrate 100. In an embodiment, the tip TP of the metal pattern layer ML may have a declined slope extending in the direction (e.g., the - z direction) towards the top surface 100t of the substrate 100.

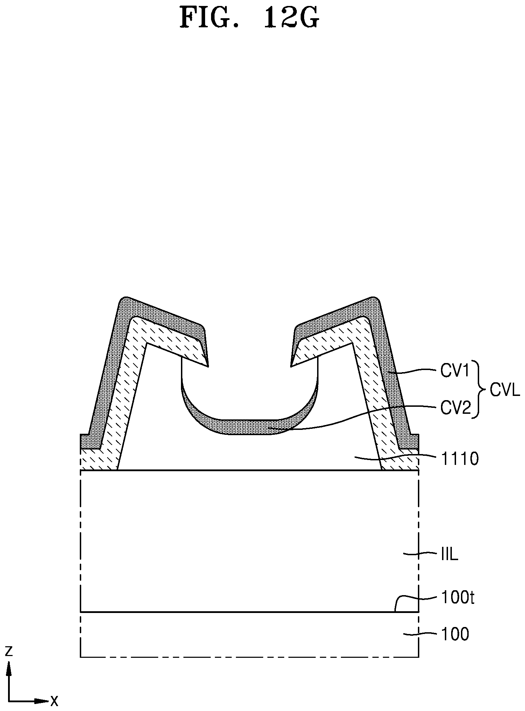

Referring to FIG. 12G, the cover layer CVL may be formed on (e.g., formed directly thereon) the metal pattern layer ML. The cover layer CVL may form the first cover portion CV1, which covers the top surface and the side surfaces of the metal pattern layer ML, and the second cover portion CV2 in the groove G. In an embodiment, the cover layer CVL and the subpixel electrode 210 on the display area DA may be simultaneously formed in a same process.

In an embodiment, the organic pattern layer 1110, the metal pattern layer ML, and the cover layer CVL included in the separator SP arranged in the middle area MA and structures on the display area DA may be formed in a same process, and therefore, a process of manufacturing the display apparatus 10 may be simplified.

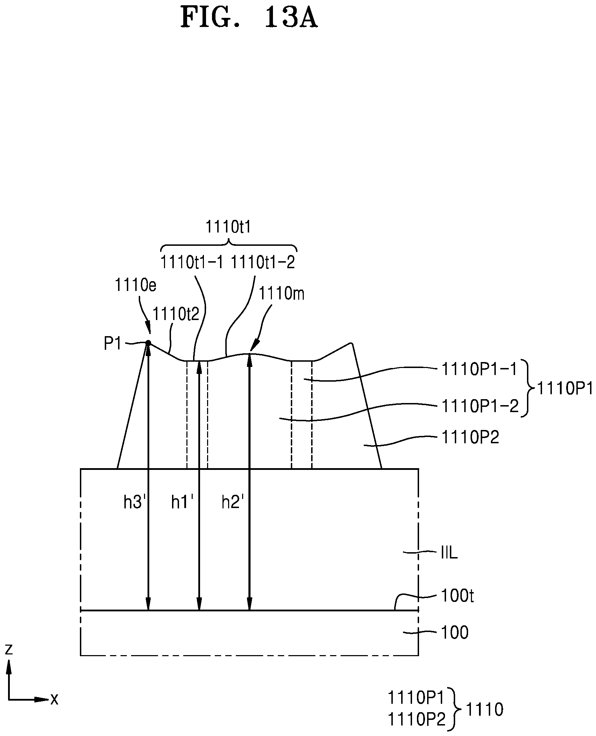

FIGS. 13A to 13D are cross-sectional views briefly illustrating a method of manufacturing the separators SP included in the display apparatus according to an embodiment, which illustrate an embodiment modified from embodiments in FIGS. 12A to 12G. The separators SP illustrated in FIG. 9A may be formed through a process illustrated in FIGS. 13A to 13D. Hereinafter, a repeated description of identical or similar elements may be omitted, and differences will be mainly described for economy of explanation.

The process shown in FIG. 12A may be applied to the present embodiment. In an embodiment, in a process of patterning the organic pattern layer 1110 using the first mask MS1 shown in FIG. 12A, the organic pattern layer 1110 illustrated in FIG. 13A may be formed.

Referring FIG. 13A, according to the characteristics of the phase shift pattern RP, the organic pattern layer 1110 formed by the first mask MS1 may include the center portion 1110P1 and the edge portion 1110P2. Unlike in the embodiment in FIG. 12B, in the embodiment in FIG. 13A, the center portion 1110P1 of the organic pattern layer 1110 may include a first center portion 1110P1-1 adjacent to the edge portion 1110P2 and a second center portion 1110P1-2 inside the first center portion 1110P1-1. In an embodiment, an average thickness (e.g., length in the z direction) of the second center portion 1110P1-2 of the organic pattern layer 1110 may be greater than an average thickness (e.g., length in the z direction) of the first center portion 1110P1-1 of the organic pattern layer 1110. In addition, the average thickness of the second center portion 1110P1-2 of the organic pattern layer 1110 may be less than the average thickness of the edge portion 1110P2 of the organic pattern layer 1110. An embodiment shown in FIG. 12B and an embodiment shown in FIG. 13A may be formed by the first mask MS1 (see FIG. 12A) including the phase shift pattern RP (see FIG. 12A), and the embodiment shown in FIG. 13A may be formed in a shape in which a portion of the center portion 1110P1 protrudes in a curing process after the patterning.

For example, a vertical distance h2' from the top surface 100t of the substrate 100 to a top surface 1110t1-2 of the second center portion 1110P1-2 of the organic pattern layer 1110 may be greater than or equal to a vertical distance h1' from the top surface 100t of the substrate 100 to a top surface 1110t1-1 of the first center portion 1110P1-1 of the organic pattern layer 1110. In an embodiment, the vertical distance h2' from the top surface 100t of the substrate 100 to the top surface 1110t1-2 of the second center portion 1110P1-2 may decrease towards the first center portion 1110P1-1 of the organic pattern layer 1110. In addition, the vertical distance h1' from the top surface 100t of the substrate 100 to the top surface 1110t1-1 of the first center portion 1110P1-1 of the organic pattern layer 1110 may be less than or equal to a vertical distance h3' from the top surface 100t of the substrate 100 to the top surface 1110t2 of the edge portion 1110P2 of the organic pattern layer 1110. In an embodiment, the vertical distance h3' from the top surface 100t of the substrate 100 to the top surface 1110t2 of the edge portion 1110P2 of the organic pattern layer 1110 may decrease towards the first center portion 1110P1-1 of the organic pattern layer 1110.

The top surface 1110t2 of the edge portion 1110P2 of the organic pattern layer 1110 may include the first point P1 which is the surface of the organic pattern layer 1110 having the greatest vertical distance from the top surface 100t of the substrate 100.

In a cross-section, the top surface 1110t2 of the edge portion 1110P2 of the organic pattern layer 1110 may have a declined slope extending in the direction (the - z direction) towards the top surface 100t of the substrate 100. Although FIG. 13A illustrates that the top surface 1110t2 of the edge portion 1110P2 of the organic pattern layer 1110 includes a declined slope having a constant angle, in some embodiments the top surface 1110t2 of the edge portion 1110P2 of the organic pattern layer 1110 may include slopes respectively having different angles. For example, in some embodiments the top surface 1110t2 of the edge portion 1110P2 of the organic pattern layer 1110 may have a shape having an inclined slow extending in a direction away from the top surface 100t of the substrate 100. In an embodiment, the end portion 1110e of the edge portion 1110P2 of the organic pattern layer 1110, which corresponds to the first point P1, may have the shape having an inclined slope extending in the direction (e.g., the z direction) away from the top surface 100t of the substrate 100.

At least a portion of the top surface 1110t1-1 of the first center portion 1110P1-1 of the organic pattern layer 1110 may extend parallel to the top surface 100t of the substrate 100. For example, as illustrated in FIG. 13A, the top surface 1110t1-1 of the first center portion 1110P1-1 of the organic pattern layer 1110 may extend generally parallel to the top surface 100t of the substrate 100.

In an embodiment, the top surface 1110t1-2 of the second center portion 1110P1-2 of the organic pattern layer 1110 may have an inclined slope in the direction (e.g., the z direction) away from the top surface 100t of the substrate 100. The top surface 1110t1-2 of the second center portion 1110P1-2 of the organic pattern layer 1110 may include slopes respectively having different angles. For example, a portion adjacent to the first center portion 1110P1-1 in the second center portion 1110P1-2 of the organic pattern layer 1110 and the top surface 1110t1-2 of the second center portion 1110P1-2 of the organic pattern layer 1110, which corresponds to a center portion 1110m, may be almost parallel to the top surface 100t of the substrate 100. In an embodiment, the angle of the slopes may increase away from the first center portion 1110P1-1 near the first center portion 1110P1-1 of the organic pattern layer 1110, and then may decrease toward the center portion 1110m near the center portion 1110m. The center portion 1110m of the second center portion 1110P-2 of the organic pattern layer 1110 may have a shape protruding in the direction (e.g., the z direction) away from the top surface 100t of the substrate 100.

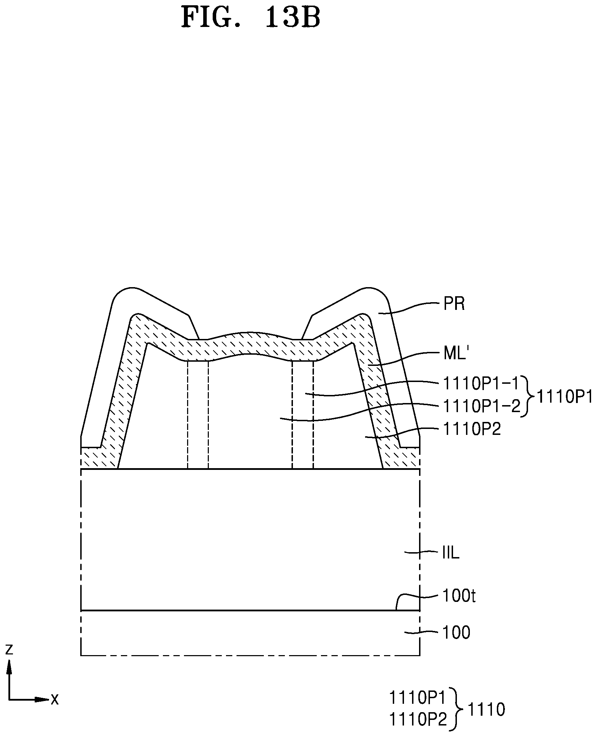

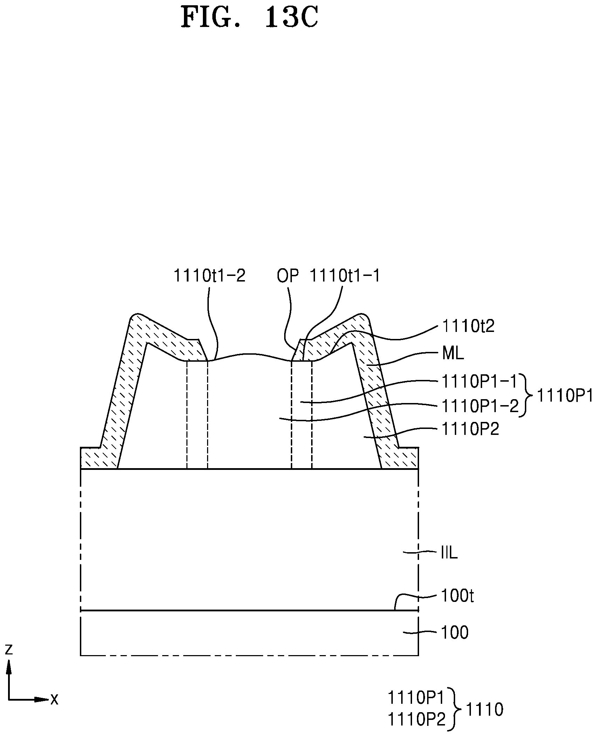

Referring to FIGS. 13B and 13C, the preliminary-metal pattern layer ML' may be formed on (e.g., formed directly thereon) the organic pattern layer 1110. A photoresist pattern PR may be formed on (e.g., formed directly thereon) the preliminary-metal pattern layer ML'. In an embodiment, the metal pattern layer ML may then be formed by patterning the preliminary-metal pattern layer ML' using the photoresist pattern PR.

A form of the metal pattern layer ML may vary according to a form of the photoresist pattern PR. In an embodiment, as illustrated in FIG. 13B, the photoresist pattern PR may overlap (e.g., in the z direction) the first center portion 1110P1-1 of the organic pattern layer 1110 and may not overlap (e.g., in the z direction) the second center portion 1110P1-2. In this embodiment, the metal pattern layer ML that is patterned may include the opening OP overlapping the first center portion 1110P1-1 of the organic pattern layer 1110 and exposing the second center portion 1110P1-2 of the organic pattern layer 1110. The opening OP may expose the top surface 1110t1-2 of the second center portion 1110P1-2 of the organic pattern layer 1110.

In an embodiment, an end portion of the metal pattern layer ML may be disposed on the top surface 1110t1-1 of the first center portion 1110P1-1 of the organic pattern layer 1110. The end portion of the metal pattern layer ML may extend parallel to the top surface 100t of the substrate 100.

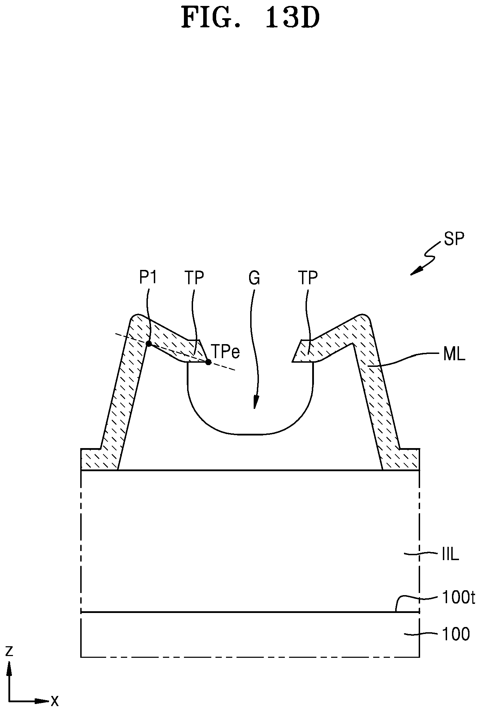

Referring to FIGS. 13C and 13D, the groove G may be formed by removing a portion of the organic pattern layer 1110 using the metal pattern layer ML as a mask. In an embodiment, the second center portion 1110P1-2 and the first center portion 1110P1-1 of the organic pattern layer 1110 may be at least partially removed. The tip TP provided at the end portion of the metal pattern layer ML may be formed. The virtual line passing the first point P1 of the organic pattern layer 1110 and the edge TPe of the tip TP of the metal pattern layer ML may have an declined slope extending in the direction (e.g., the - z direction) towards the top surface 100t of the substrate 100. In an embodiment, at least a portion of the tip TP of the metal pattern layer ML may extend parallel to the top surface 100t of the substrate 100.

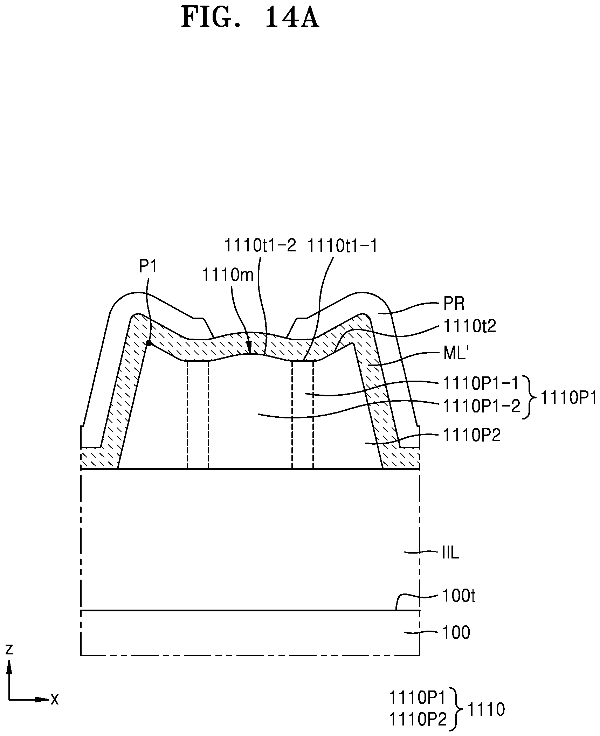

FIGS. 14A to 14C are cross-sectional views briefly illustrating a method of manufacturing the separators SP included in the display apparatus 10 according to an embodiment. FIGS. 14A to 14C illustrate embodiments modified from embodiments illustrated in FIGS. 13A to 13D. The separators SP illustrated in FIG. 9B may be formed through a process illustrated in FIGS. 14A to 14C. Hereinafter, differences will be mainly described, and a repeated descriptions of identical or similar elements may be omitted for economy of description.

Like in the embodiment shown in FIGS. 13A to 13D, in the process of patterning the organic pattern layer 1110 using the first mask MS1 illustrated in FIG. 12A, the organic pattern layer 1110 having the form shown in FIG. 13A may be formed.

Referring to FIG. 14A, the preliminary-metal pattern layer ML' may be formed on (e.g., formed directly thereon) the organic pattern layer 1110. The photoresist pattern PR may be formed on the preliminary-metal pattern layer ML'. In an embodiment, the metal pattern layer ML may then be formed by patterning the preliminary-metal pattern layer ML' using the photoresist pattern PR.

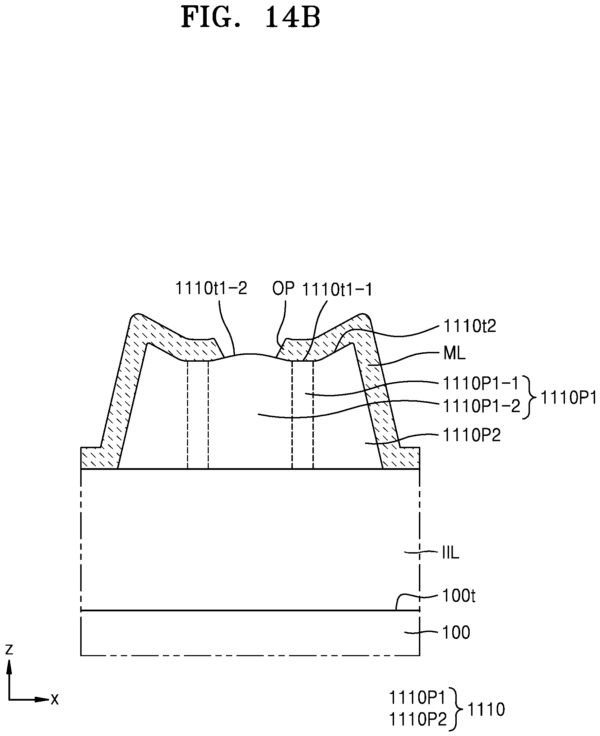

A form of the metal pattern layer ML may vary according to a form of the photoresist pattern PR. Unlike an embodiment shown in FIG. 13B, in an embodiment shown in FIG. 14A, the photoresist pattern PR partially overlaps (e.g., in the z direction) the first center portion 1110P1-1 and the second center portion 1110P1-2 of the organic pattern layer 1110, and may not overlap (e.g., in the z direction) a portion of the second center portion 1110P1-2 including the center portion 1110m. Referring to the FIG. 14B, in this embodiment, the metal pattern layer ML may partially overlap the first center portion 1110P1-1 and the second center portion 1110P1-2 of the organic pattern layer 1110, and may include the opening OP exposing a portion of the second center portion 1110P1-2. The opening OP may expose a portion of the top surface 1110t1-2 of the second center portion 1110P1-2 of the organic pattern layer 1110.

In an embodiment, an end portion of the metal pattern layer ML may be disposed on the top surface 1110t1-2 of the second center portion 1110P1-2 of the organic pattern layer 1110. Accordingly, the end portion of the metal pattern layer ML may have an inclined slope extending in the direction (e.g., the z direction) away from the top surface 100t of the substrate 100.

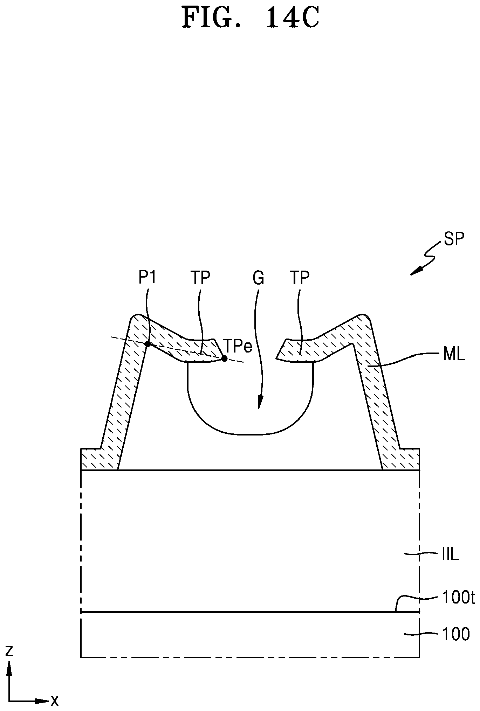

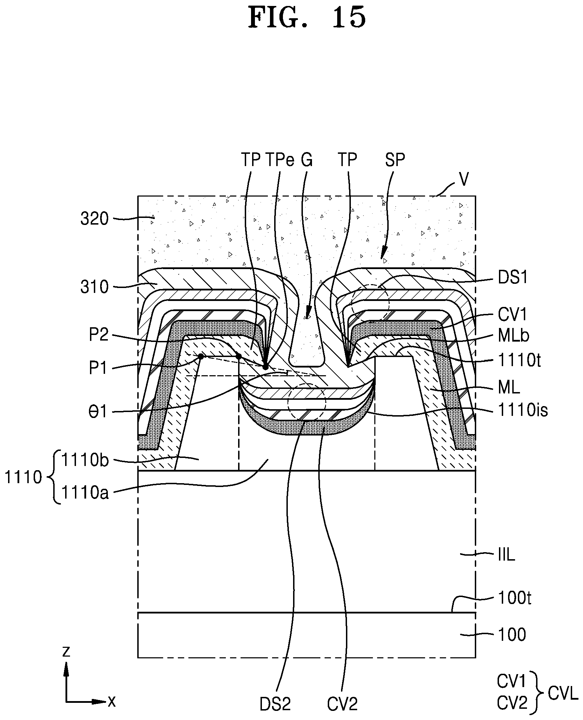

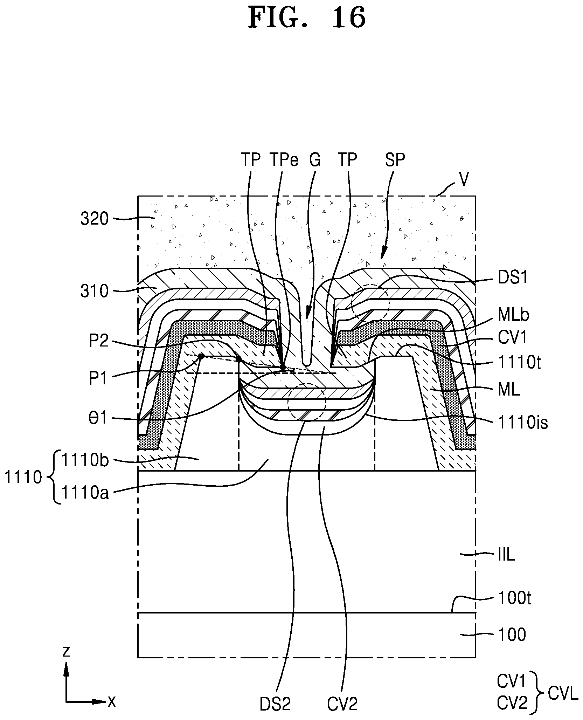

Referring to FIGS. 14B and 14C, the groove G may be formed by removing a portion of the organic pattern layer 1110 by using the metal pattern layer ML as a mask. In an embodiment, the second center portion 1110P1-2 and the first center portion 1110P1-1 of the organic pattern layer 1110 may be at least partially removed. The tip TP provided at the end portion of the metal pattern layer ML may be formed. The virtual line passing the first point P1 of the organic pattern layer 1110 and the edge TPe of the tip TP of the metal pattern layer ML may have a declined slope extending in the direction (e.g., the - z direction) towards the top surface 100t of the substrate 100. In an embodiment, at least a portion of the tip TP of the metal pattern layer ML may have an inclined slope extending in the direction (e.g., the z direction) away from the top surface 100t of the substrate 100. FIG. 15 is a cross-sectional view of a portion of a display apparatus according to an embodiment; FIG. 16 illustrates an embodiment modified from an embodiment shown in FIG. 15, and FIG. 15 illustrates an embodiment modified from the embodiment shown in FIG. 8. Hereinafter, differences will be mainly described, and a repeated descriptions of identical or similar elements may be omitted for economy of description..

Referring to FIGS. 15 and 16, the separator SP may have a stack structure including the organic pattern layer 1110 and the metal pattern layer ML. In an embodiment, the separator SP may include the groove G and two tips arranged at two sides (e.g., lateral sides) of the groove G (e.g., in a cross-sectional view). The tip TP may overlap the groove G (e.g., in the z direction).

The organic pattern layer 1110 may include a first portion 1110a overlapping the groove G (e.g., in the z direction) and a second portion 1110b extending to the outside of the first portion 1110a and not overlapping the groove G (e.g., in the z direction). The second portion 1110b may include an edge portion of the organic pattern layer 1110.

In an embodiment, as illustrated in FIG. 15, the top surface 1110t corresponding to the second portion 1110b of the organic pattern layer 1110 may not include a slope. The top surface 1110t corresponding to the second portion 1110b of the organic pattern layer 1110 may extend generally parallel to the top surface 100t of the substrate 100. However, embodiments of the present disclosure are not necessarily limited thereto. In some embodiments, as illustrated in FIG. 16, the top surface corresponding to at least a part of the second portion 1110b of the organic pattern layer 1110, such as a portion of the second portion 1110b adjacent to the first portion 1110a, may include a slope. In an embodiment, the slope may be a declined slope extending in the direction (the -z direction) towards the top surface 100t of the substrate 100.

In a cross-section, the top surface 1110t of the organic pattern layer 1110 may include the first point P1 having the greatest vertical distance from the top surface 100t of the substrate 100. For example, the top surface 1110t of the second portion 1110b of the organic pattern layer 1110 may include the first point P1 having the greatest vertical distance from the top surface 100t of the substrate 100.

The metal pattern layer ML may be disposed on (e.g., disposed directly thereon) the top surface 1110t of the organic pattern layer 1110. The metal pattern layer ML may include the tip TP. The tip TP may include a portion extending from the second point P2, at which the internal surface 1110is of the organic pattern layer 1110 meets the bottom surface MLb of the metal pattern layer ML, towards the center of the groove G. In an embodiment, as illustrated in FIG. 15, the tip TP of the metal pattern layer ML may not extend parallel to the top surface 100t of the substrate 100. In an embodiment, the tip TP of the metal pattern layer ML may have a declined slope extending in the direction (e.g., the - z direction) towards the top surface 100t of the substrate 100. However, embodiments of the present disclosure are not necessarily limited thereto. For example, in some embodiments, as illustrated in FIG. 16, at least a portion of the tip TP of the metal pattern layer ML may extend parallel to the top surface 100t of the substrate 100. For example, the edge TPe of the tip TP of the metal pattern layer ML may extend parallel to the top surface 100t of the substrate 100. In the tip TP of the metal pattern layer ML, a remaining portion other than the portion including the edge TPe may have a declined slope extending in the direction (the - z direction) towards the top surface 100t of the substrate 100.

The virtual line passing the first point P1 of the organic pattern layer 1110 and the edge TPe of the tip TP of the metal pattern layer ML may have a declined slope extending in the direction (e.g., the - z direction) towards the top surface of the substrate 100. In an embodiment, an angle θ1 formed by the virtual line passing the first point P1 of the organic pattern layer 1110 and the edge TPe of the tip TP of the metal pattern layer ML and the top surface 100t of the substrate 100 may be greater than 0° but less than 90°.

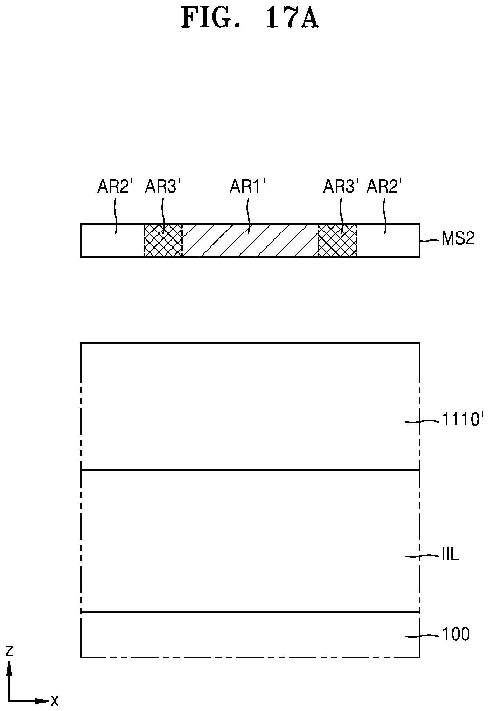

In an embodiment, among the layers disposed on metal pattern layer ML, such as the first dummy stack DS1 including the first cover portion CV1 of the cover layer CVL, the function layer 220f, and the counter electrode 230, a portion disposed on the tip TP of the metal pattern layer ML may have a slope structure identical to a slope structure of the tip TP. FIGS. 17A to 17E are cross-sectional views briefly illustrating a method of manufacturing the separator SP of the display apparatus 10 according to an embodiment. The separator SP illustrated in FIG. 15 may be formed through a process shown in FIGS. 17A to 17E. FIGS. 17A to 17E illustrate an embodiment modified from the embodiment shown in FIGS. 12A to 12F. Hereinafter, differences will be mainly described, and a repeated descriptions of identical or similar elements may be omitted for economy of description.

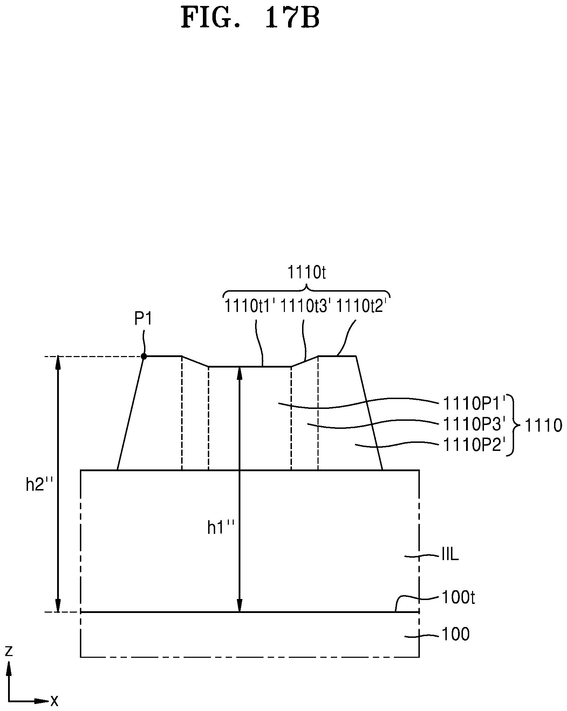

Referring to FIGS. 17A and 17B, the inorganic insulating layer IIL and the preliminary-organic pattern layer 1110' may be formed on the substrate 100. A second mask MS2 may be placed on (e.g., disposed directly thereon) the preliminary-organic pattern layer 1110'. In an embodiment, the second mask MS2 may include a half-tone mask or a slit. The second mask MS2 may include a first portion AR1, a second portion AR2', and a third portion AR3'.

The preliminary-organic pattern layer 1110' may be exposed through the second mask MS2 in different exposure amounts according to portions. In an embodiment, in the second mask MS2, the first portion AR1' may include a semi-transmitter, the second portion AR2' may include a transmitter, and the third portion AR3' may include a light-shielding unit. Transmittance of the first portion AR1' of the second mask MS2 may be less than transmittance of the second portion AR2' and greater than transmittance of the third portion AR3'.

In an embodiment, the preliminary-organic pattern layer 1110' may then be patterned through the developing process to form the organic pattern layer 1110.

A center portion 1110P1' of the organic pattern layer 1110 may include a portion exposed by the first portion AR1' of the second mask MS2. An edge portion 1110P2' of the organic pattern layer 1110 may include a portion exposed by the third portion AR3' of the second mask MS2. A portion exposed by the second portion AR2' of the second mask MS2 may be removed from the preliminary-organic pattern layer 1110' in the developing process. A slope portion 1110P3' may be between the center portion 1110P1' and the edge portion 1110P2' of the organic pattern layer 1110.

The top surface 1110t2 of the edge portion 1110P2 of the organic pattern layer 1110 may include the first point P1 having the greatest vertical distance from the top surface 100t of the substrate 100. A thickness (e.g., length in the z direction) of the center portion 1110P1' of the organic pattern layer 1110 may be less than a thickness (e.g., length in the z direction) of the edge portion 1110P2' of the organic pattern layer 1110. For example, a vertical distance h1" from the top surface 100t of the substrate 100 to the top surface 1110t1' of the center portion 1110P1' of the organic pattern layer 1110 may be less than a vertical distance h2" from the top surface 100t of the substrate 100 to the top surface 1110t2' of the edge portion 1110P2' of the organic pattern layer 1110.

In a cross-section, a top surface 1110t3' of the slope portion 1110P3' of the organic pattern layer 1110 may have a declined slope extending in the direction (the - z direction) towards the top surface 100t of the substrate 100.

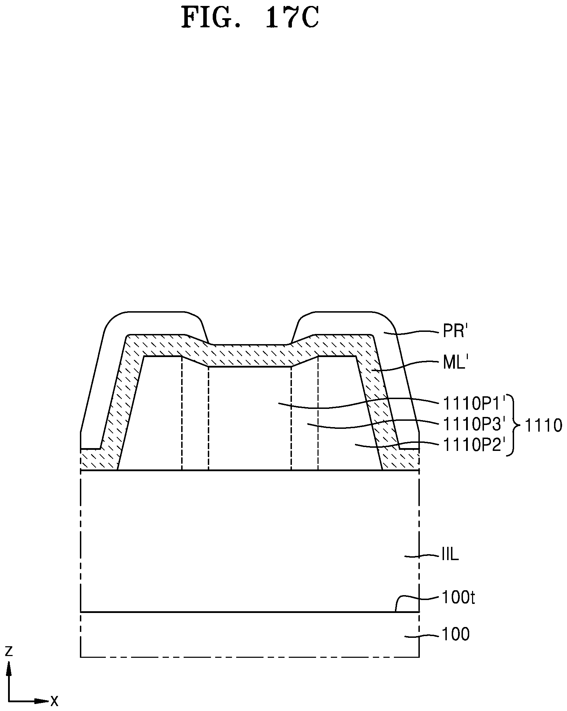

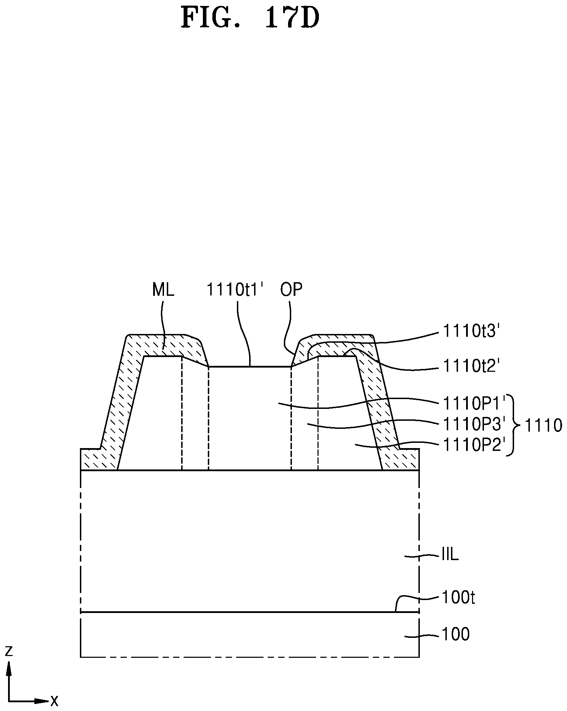

Referring to FIGS. 17C and 17D, the preliminary-metal pattern layer ML' may be formed on (e.g., formed directly thereon) the organic pattern layer 1110. The photoresist pattern PR' may be formed on (e.g., formed directly thereon) the preliminary-metal pattern layer ML'. The metal pattern layer ML may be formed by patterning the preliminary-metal pattern layer ML'. The photoresist pattern PR' may overlap (e.g., in the z direction) the edge portion 1110P2' and the slope portion 1110P3' of the organic pattern layer 1110, and may not overlap (e.g., in the z direction) the center portion 1110P1' of the organic pattern layer 1110. The metal pattern layer ML may include the opening OP exposing the center portion 1110P1' of the organic pattern layer 1110. The opening OP may expose the top surface 1110t1' of the center portion 1110P1' of the organic pattern layer 1110. An end portion of the metal pattern layer ML may be disposed on the top surface 1110t3' of the slope portion 1110P3' of the organic pattern layer 1110. An end portion of the metal pattern layer ML may have a declined slope extending in the direction (e.g., the - z direction) towards the top surface 100t of the substrate 100.

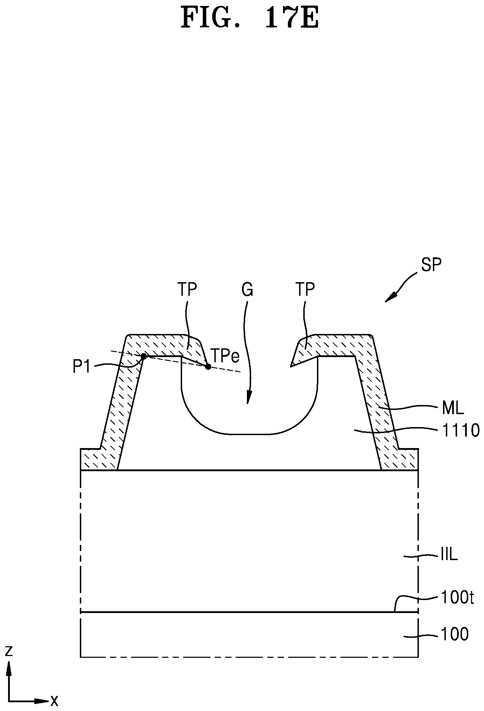

Referring to FIG. 17E, the groove G may be formed by removing a portion of the organic pattern layer 1110 by using the organic pattern layer 1110 as a mask. For example, the center portion 1110P1' and the slope portion 1110P3' of the organic pattern layer 1110 may be at least partially removed. The tip TP provided at the end portion of the metal pattern layer ML may be formed. The virtual line passing the first point P1 of the organic pattern layer 1110 and the edge TPe of the tip TP of the metal pattern layer ML may have a declined slope extending in the direction (e.g., the - z direction) towards the top surface 100t of the substrate 100. In an embodiment, the tip TP of the metal pattern layer ML may have a declined slope extending in the direction (e.g., the - z direction) towards the top surface 100t of the substrate 100.

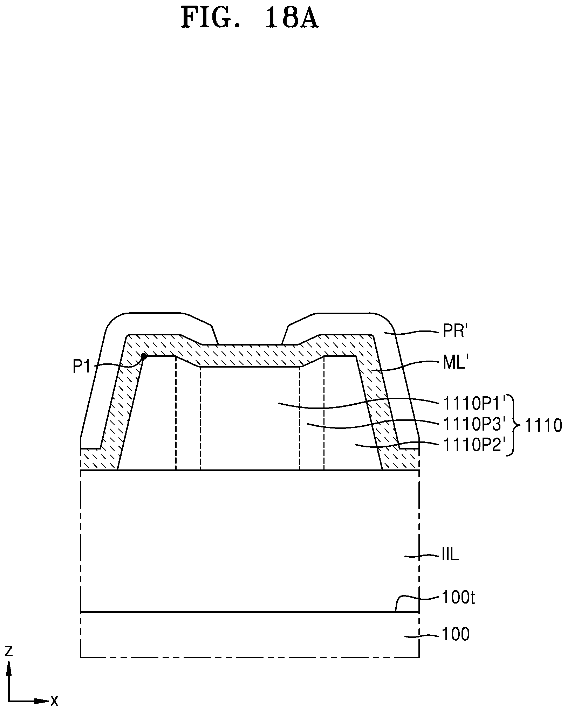

FIGS. 18A to 18C are cross-sectional views briefly illustrating a method of manufacturing the separator SP of the display apparatus according to an embodiment. The separator SP shown in FIG. 16 may be formed through a process shown in FIGS. 18A to 18C. FIGS. 18A to 18C illustrate an embodiment modified from an embodiment shown in FIG. 17E. Hereinafter, differences will be mainly described, and a repeated descriptions of identical or similar elements may be omitted for economy of description.

Like in the embodiment shown in FIGS. 17A to 17E, in the process of patterning the organic pattern layer 1110 using the second mask MS2 shown in FIG. 17A, the organic pattern layer 1110 having the form shown in FIG. 17B may be formed.

Referring to FIG. 18A, the preliminary-metal pattern layer ML' may be formed on (e.g., formed directly thereon) the organic pattern layer 1110. A photoresist pattern PR' may be formed on (e.g., formed directly thereon) the preliminary-metal pattern layer ML'. In an embodiment, the metal pattern layer ML may then be formed by patterning the preliminary-metal pattern layer ML' using the photoresist pattern PR'.

The form of the metal pattern layer ML may vary according to a form of the photoresist pattern PR'. Unlike in an embodiment shown in FIG. 17C, in an embodiment shown in FIG. 18A, the photoresist pattern PR' may overlap (e.g., in the z direction) the edge portion 1110P2', the slope portion 1110P3', and a portion of the center portion 1110P1' of the organic pattern layer 1110, and may not overlap (e.g., in the z direction) another portion of the center portion 1110P1' of the organic pattern layer 1110. In this embodiment, the metal pattern layer ML may overlap (e.g., in the z direction) the edge portion 1110P2', the slope portion 1110P3', and the portion of the center portion 1110P1', and may include the opening OP exposing a portion of the center portion 1110P1' of the organic pattern layer 1110. The opening OP may expose a portion of the top surface 1110t1' of the center portion 1110P1' of the organic pattern layer 1110.

In an embodiment, an end portion of the metal pattern layer ML may be disposed on the top surface 1110t1' of the center portion 1110P1' of the organic pattern layer 1110. Accordingly, the end portion of the metal pattern layer ML may extend parallel to the top surface 100t of the substrate 100.

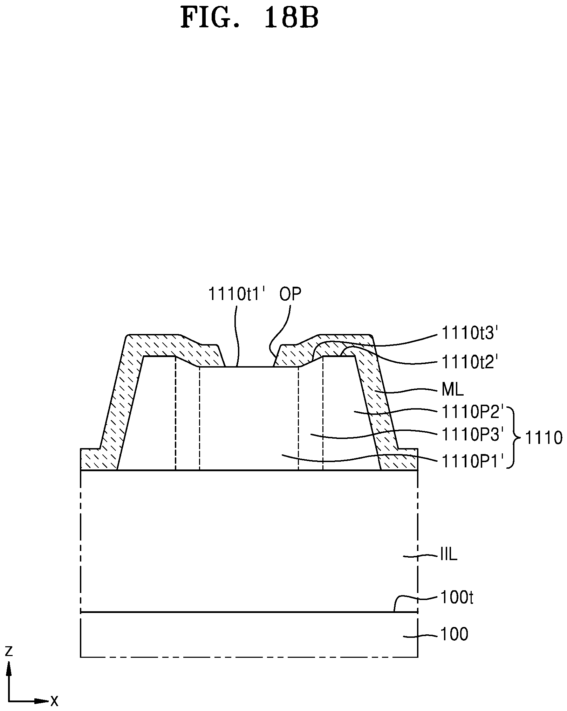

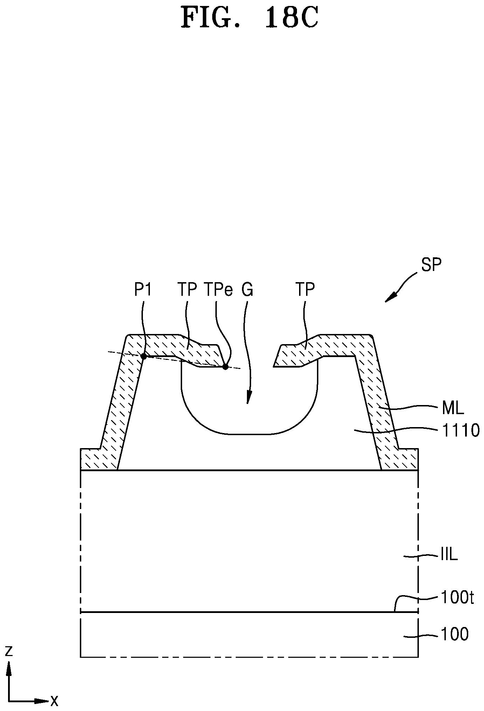

Referring to FIGS. 18B and 18C, the groove G may be formed by removing a portion of the organic pattern layer 1110 by using the metal pattern layer ML as a mask. In an embodiment, the center portion 1110P1' and the slope portion 1110P3' of the organic pattern layer 1110 may be at least partially removed. The tip TP provided at the end portion of the metal pattern layer ML may be formed. The virtual line passing the first point P1 of the organic pattern layer 1110 and the edge TPe of the tip TP of the metal pattern layer ML may have a declined slope extending in the direction (e.g., the - z direction) towards the top surface 100t of the substrate 100. In an embodiment, at least a portion of the tip TP of the metal pattern layer ML may extend parallel to the top surface 100t of the substrate 100.

According to embodiments described above, a display apparatus having areas for arranging various kinds of components in a display area and of which the reliability is increased may be implemented. However, the scope of embodiments of the present disclosure are not necessarily limited thereto.

It should be understood that embodiments described herein should be considered in a descriptive sense only and not for purposes of limitation. Descriptions of features or aspects within each embodiment should typically be considered as available for other similar features or aspects in embodiments. While one or more embodiments have been described with reference to the figures, it will be understood by those of ordinary skill in the art that various changes in form and details may be made therein without departing from the scope of the present disclosure.

## Claims

1. A display apparatus (10) comprising:
a substrate (100) comprising a first area, a second area surrounding at least a portion of the first area, and a third area between the first area and the second area;
a light-emitting diode arranged in the second area and comprising a subpixel electrode (210), a counter electrode (230), and an intermediate layer (220) between the subpixel electrode (210) and the counter electrode (230); and
a first separator (SP) arranged in the third area,
wherein the first separator comprises:
an organic pattern layer (1110) disposed on the substrate (100) and having a groove (G); and
a metal pattern layer (ML) disposed on a top surface (1110t) of the organic pattern layer (1110) and comprising a tip (TP) extending towards a center of the groove,
wherein, in a cross-section, the top surface (1110t) of the organic pattern layer (1110) comprises a first point (P1) having a greatest vertical distance from a top surface (100t) of the substrate (100), and
an imaginary line passing through the first point of the organic pattern layer (1110) and an edge (TPe) of the tip of the metal pattern layer has a declined slope extending in a direction towards the top surface (100t') of the substrate (100).

2. The display apparatus (10) of claim 1, wherein:
the organic pattern layer (1110) comprises a first portion (1110a) overlapping the groove (G) and a second portion (1110b) outside the first portion (1110a), the second portion (1110b) does not overlap the groove; and
a top surface (1110t) of the second portion (1110b) comprises a slope in a direction toward the top surface(100t) of the substrate(100).

3. The display apparatus (10) of claim 1 or 2, wherein the metal pattern layer (ML) at least partially covers the top surface (1110t) and an outer surface of the organic pattern layer (1110).

4. The display apparatus (10) of any of the preceding claims, wherein at least a portion of the tip (TP) of the metal pattern layer (ML) has a declined slope extending in the direction towards the top surface (100t) of the substrate (100).

5. The display apparatus (10) of any of claims 1 to 3, wherein at least a portion of the tip (TP) of the metal pattern layer (ML) extends parallel to the top surface (100t) of the substrate (100).

6. The display apparatus of any of claims 1 to 3, wherein at least a portion of the tip (TP) of the metal pattern layer (ML) has an inclined slope extending in a direction away from the top surface (100t) of the substrate (100).

7. The display apparatus (10) of any of the preceding claims, further comprising:
an inorganic insulating layer (IIL) disposed on the substrate (100), the organic pattern layer (1110) is disposed directly on the inorganic insulating layer (IIL);
a second separator spaced apart from the first separator, in the third area; and
the third area comprises an inorganic contact region (ICR) in an interval between the first separator and the second separator,
wherein the metal pattern layer (ML) directly contacts a top surface of the inorganic insulating layer in the inorganic contact region.

8. The display apparatus (10) of any of the preceding claims, further including a cover layer (CVL) comprising:
a first cover portion (CV1) covering a top surface (MLt) and a side surface (MLs) of the metal pattern layer (ML); and
a second cover portion (CV2) arranged in the groove (G).

9. The display apparatus (10) of claim 8, wherein the cover layer (CVL) comprises a same material as a material of the subpixel electrode (210).

10. The display apparatus (10) of any of the preceding claims, wherein the metal pattern layer (ML) comprises:
a first sublayer (ML1), a second sublayer (ML2), and a third sublayer (ML3), that are sequentially stacked,
wherein the third sublayer (ML3) extends from a point where a side surface of the second sublayer meets a bottom surface of the third sublayer towards a center of the groove, and/or wherein:
the intermediate layer (220) comprises at least one organic material layer (220f); and
the at least one organic material layer (220f) and the counter electrode (230) are isolated from each other by the first separator in the third area.

11. A method of manufacturing a display apparatus (10) of any of the preceding claims, the method comprising:
preparing a substrate (100) comprising a first area, a second area surrounding at least a portion of the first area, and a third area between the first area and the second area;
forming an organic pattern layer (1110) in the third area;
forming a metal pattern layer (ML) on the organic pattern layer (1110);
forming a first separator (SP) including a groove (G) and a tip (TP) by removing a portion of the organic pattern layer (1110); and
forming in the second area, a light-emitting diode including a subpixel electrode (210), a counter electrode (230), and an intermediate layer (220) between the subpixel electrode (210) and the counter electrode (230),
wherein, in a cross-section, a top surface (1110t) of the organic pattern layer (1110) comprises a first point having a greatest vertical distance from a top surface (100t) of the substrate (100), and
the metal pattern layer (ML) comprises the tip (TP) extending towards a center of the groove, and
an imaginary line passing through the first point (P1) of the organic pattern layer (1110) and an edge (TPe) of the tip of the metal pattern layer has a declined slope extending in a direction towards the top surface (100t) of the substrate (100).

12. The method of claim 11, wherein the forming of the organic pattern layer (1110) comprises:
forming a preliminary-organic pattern layer (1110') on the substrate (100);
disposing a mask on the preliminary-organic pattern layer (1110'); and
exposing and developing the preliminary-organic pattern layer (1110') by using the mask.

13. The method of claim 11 or 12, wherein the forming of the organic pattern layer (1110) is performed using a phase shift mask, or wherein the forming of the organic pattern layer (1110) is performed using a half-tone mask or a slit.

14. The method of any of claims 11 to 13, wherein:
the organic pattern layer (1110) comprises a center portion (1110P1, 1110P1') and an edge portion (1110P2, 1110P2'); and
a vertical distance from the top surface (100t) of the substrate (100) to a top surface (1110t1, 1110t1') of the center portion (1110P1, 1110P1') is less than a vertical distance from the top surface (100t) of the substrate (100) to a top surface (1110t1110t2, 1110t2') of the edge portion (1110P2, 1110P2'), and/or wherein the forming of the metal pattern layer (ML) comprises:
forming a preliminary-metal pattern layer (ML'); and
forming a metal pattern layer comprising an opening (OP) by patterning the preliminary-metal pattern layer (ML'),
wherein the opening (OP) in the metal pattern layer exposes at least a portion of the center portion (1110P1, 1110P1', 1110m) of the organic pattern layer (1110).

15. The method of any of claims 11 to 14, wherein the removing of the portion of the organic pattern layer (1110) comprises ashing the organic pattern layer (1110) by using the metal pattern layer as a mask, and/or further comprising forming on the metal pattern layer, a cover layer comprising a same material as a material of the subpixel electrode (210), and/or further comprising forming an opening area overlapping the first area in the substrate (100).

16. An electronic device (1) including the display apparatus (10) of any of claims 1 to 10.

17. The electronic device (1) of claim 16, wherein the electronic device is at least one of a television, a notebook, a monitor, a billboard chart, an Internet of Things (IOT), a mobile phone, a smart phone, a tablet personal computer, a mobile communication terminal, an electronic organizer, an electronic book, a portable multimedia player, a navigation device, an ultra-mobile personal computer, a smart watch, a watch phone, or a head mounted display.
